# EUROPÄISCHE PATENTSCHRIFT

(11) **EP 3 762 150 B1**
(45) Veröffentlichungstag und Bekanntmachung des Hinweises auf die Patenterteilung: **28.08.2024**
(21) Anmeldenummer: 19706488.4
(22) Anmeldetag: 15.02.2019
(51) Int. Cl.: A24F 40/70, A24F 40/46, B05B 7/08, B05B 7/16, H05B 3/26, A24F 40/10, H01L 23/34

(54) **VERFAHREN ZUR FERTIGUNG EINES ELEKTRISCH BETREIBBAREN HEIZKÖRPERS FÜR EINEN INHALATOR**
METHOD FOR MANUFACTURING AN ELECTRICALLY OPERABLE HEATING ELEMENT FOR AN INHALER
PROCÉDÉ DE FABRICATION D'UN CORPS CHAUFFANT À COMMANDE ÉLECTRIQUE POUR UN INHALATEUR

(30) Priorität: 07.03.2018 DE 102018105220
(43) Veröffentlichungstag der Anmeldung: 13.01.2021
(73) Patentinhaber: Körber Technologies GmbH, 21033 Hamburg (DE)
(72) Erfinder: PELZ, Uwe, 79227 Schallstadt (DE); GHANAM, Muhannad, 79114 Freiburg (DE); JAKLIN, Jan, 70736 Fellbach (DE); WOIAS, Peter, 79100 Freiburg (DE); RATH, Sonali, 91560 Heilsbronn (DE); GOLDSCHMIDTBÖING, Frank, 77799 Ortenberg (DE)
(74) Vertreter: Müller Verweyen
(86) Internationale Anmeldenummer: PCT/EP2019/053813
(87) Internationale Veröffentlichungsnummer: WO 2019/170394

(56) Entgegenhaltungen:
- WO-A1-2018/083007
- DE-A1- 102004 051 364
- US-A1- 2005 109 768
- US-A1- 2014 060 554
- US-A1- 2015 114 409
- US-A1- 2017 108 210
- US-A1- 2017 280 776

## Beschreibung

Die vorliegende Erfindung betrifft ein Verfahren zur Fertigung eines elektrisch betreibbaren, insbesondere planaren Heizkörpers für einen Inhalator, insbesondere für ein elektronisches Zigarettenprodukt, vorzugsweise zum Verdampfen von Flüssigkeit.

Des Weiteren betrifft die Erfindung einen nach dem vorgenannten Verfahren gefertigten Heizkörper sowie einen Wafer mit derartigen Heizkörpern.

In der WO 2014/037794 A2 ist es offenbart, einen Heizkörper für ein elektronisches Zigarettenprodukt als ein Mikro-Elektro-Mechanisches System (MEMS) bereitzustellen. Hierfür wird unter anderem Silizium als ein in Frage kommendes Material genannt.

Auch die US 2016/0007653 A1 offenbart einen MEMS-Heizkörper für ein elektronisches Zigarettenprodukt.

Die DE 10 2016 002 665 A1 erwähnt ebenfalls einen MEMS-Heizkörper für ein elektronisches Zigarettenprodukt.

Die US 6,914,220 B2 offenbart die Fertigung eines Heizkörpers aus Silizium, allerdings für einen Gaschromatographen.

Wesentliche Probleme, die bei einfachen Metallwendelheizern, aber prinzipiell auch bei MEMS-Heizern beim Verdampfen von Flüssigkeit, einem sogenannten Liquid, auftreten können, sind der sogenannte "Dry Puff", bei dem der Heizkörper trocken, das heißt ohne hinreichende Liquidmenge heizt, was zu Beschädigungen des Heizkörpers führen kann, aber insbesondere auch zum Austreten schädlicher Bestandteile aus dem Heizkörpermaterial, das Blasensieden, bei dem es zu lokalen Überhitzungen und ungleichmäßiger Erhitzung eines Liquids kommen kann, was unter anderem zu einem explosionsartigen Spritzen von Flüssigkeit führen kann, eine Erhitzung metallischer Bestandteile oder Legierungen des Heizkörpers mit oder ohne Kontakt zu einem Liquid, bei dem es zu einer schädlichen Abgabe von Metallbestandteilen oder Metallatomen bzw. -ionen und/oder einer schädlichen, katalytischen Wirkung kommen kann, und eine unzureichend präzise elektrische Steuerung des Heizkörpers, die thermodynamisch zu einem entmischenden und/oder einem in sonstiger Weise unerwünschten Verdampfungsverhalten verschiedener Liquidbestandteile, insbesondere solcher mit unterschiedlich hohen Siedetemperaturen, führen kann.

Die US 2017/108210 A1 offenbar ein Verfahren zur Fertigung eines elektrisch betreibbaren Heizkörpers für einen Inhalator mit den Merkmalen des Oberbegriffs von Anspruch 1.

US 2015/114409 A1, DE 10 2004 051364 A1 und US 2017/280776 A1 offenbaren weitere Verfahren zur Fertigung eines elektrisch betreibbaren Heizkörpers für einen Inhalator.

Die Aufgabe der Erfindung besteht darin, ein Verfahren zur Fertigung eines Heizkörpers aufzuzeigen, das einfach, kostengünstig und reproduzierbar zur Herstellung eines Heizkörpers führt, der zudem eine gleichmäßige, gut elektrisch steuerbare und kontrollierte sowie verlässliche Erhitzung eines Substrates, insbesondere einer Flüssigkeit oder sogenannten Liquids in einem Inhalator, insbesondere einem elektronischen Zigarettenprodukt, erlaubt und gewährleistet.

Die Erfindung löst diese Aufgabe mit den Merkmalen der unabhängigen Ansprüche.

Dabei zeichnet sich das Verfahren der eingangs genannten Gattung in erfinderischer Lösung der Aufgabe dadurch aus, dass ein vorzugsweise metallfreies Halbleitermaterial im Wesentlichen plattenförmig bereitgestellt wird und eine Mehrzahl von Kanälen im Wesentlichen in Richtung der Flächennormalen des plattenförmigen Halbleitermaterials in das Halbleitermaterial eingearbeitet wird, derart, dass ein Fluid in den Kanälen durch das Halbleitermaterial hindurchleitbar ist.

Mittels der erfindungsgemäßen Fertigung eines Heizkörpers kann es mit besonderem Vorteil bei Vermeidung von metallischen Bestandteilen, zumindest der Vermeidung von "nackten" metallischen Bestandteilen des Heizkörpers, die direkt mit einem Liquid in Kontakt kommen können, vermieden werden, dass es zu einer schädlichen Abgabe von Metallbestandteilen oder Metallatomen bzw. -ionen und/oder einer schädlichen, katalytischen Wirkung kommen kann, die den zu erzeugenden Dampf oder das zu erzeugende Aerosol, das zu einer Einatmung bestimmt ist, in gesundheitsschädlicher Weise verunreinigen.

Gleichzeitig lässt sich mit weiterem Vorteil der erfindungsgemäß hergestellte Heizkörper aus einem Halbleitermaterial genauso verlässlich, gleichmäßig und präzise elektrisch steuern wie ein metallischer Heizkörper, insbesondere im Hinblick auf eine Temperatursteuerung.

Nach einem besonders vorteilhaften Aspekt kann der Heizkörper aus einem Material mit einem - mindestens in einem Arbeitsbereich, beispielsweise zwischen 100 °C und 240 °C - negativen Temperaturkoeffizienten (NTC) bestehen bzw. hergestellt werden, d.h. der elektrische Widerstand des Heizkörpers nimmt mit steigender Temperatur ab.

Durch die Verwendung eines Materials mit negativem Temperaturkoeffizienten des spezifischen Widerstands im Bereich der Solltemperatur bzw. im Arbeitsbereich einer Verdampfereinheit kann die Ausbildung von Hot-Spots bzw. Überhitzungen unterdrückt und eine homogenere Temperaturverteilung erreicht werden. Ein Heizkörper mit einem negativen Temperaturkoeffizienten kann mikromechanisch einfach auf einem Halbleitersubstrat hergestellt werden. Schlecht gekühlte Bereiche zeigen aufgrund dieses Merkmals einen niedrigeren Widerstand und somit eine verringerte Heizleistung. Der niedrigeren Kühlung wird somit entgegengewirkt.

Dies kann anhand eines vereinfachten Beispiels demonstriert werden. Der Heizkörper mit seiner Mehrzahl von Kanälen besteht modellhaft aus n in Serie geschalteten Abschnitten mit den nominell gleichen Widerständen R0 bei der Solltemperatur T0. Ein Bereich, willkürlich der Bereich 1, erfährt aufgrund eines reduzierten Wärmeabtransports eine Temperaturerhöhung um DT. Der Widerstand dieses Bereichs wird somit zu R1 = R0(1 +a*DT), wobei a den Temperaturkoeffizienten des elektrischen Widerstands bezeichnet.

In Ausführungsformen, in der eine elektrische Baueinheit Spannungsspeisung mit der Spannung U0 durchführt, fällt nun über diesen Widerstand die Spannung U1=U0*R1/(R1+(n-1)*R0) ab, während über die übrigen Widerstände jeweils die Spannung U2 = U0*R0/(R1+(n-1)*R0) abfällt. Der Strom durch die Widerstände ergibt sich zu I1= U0/(R1+(n-1)*R0). Dementsprechend ergibt sich eine Heizleistung für den ersten Abschnitt von P1 = U1*I1 = U0^2*R1/(R1+(n-1)* R0)^2 und für die übrigen Abschnitte von P2 = U2*I1 = U0^2* R0/(R1+(n-1)*R0)^2. Eine Linearisierung dieser Formel ist für geringe Temperaturen zulässig und führt zu P1 = U0^2/(n^2R0) *(1+a*DT) und P2=U0^2/(n^2R0)*(1-2a/n*DT). Die nominale Heizleistung beträgt P0=U0^2/(n^2R0). Bei Verwendung eines Materials mit negativem Temperaturkoeffizienten a<0 wird somit die Heizleistung im Bereich 1 reduziert, und in den übrigen Bereichen geringfügig erhöht. Insgesamt wird die Temperatur somit homogenisiert.

In anderen Ausführungsformen, in der die elektrische Einheit Stromspeisung mit dem Strom I0 durchführt, ergibt sich ein ähnliches Bild. Nun fällt über dem Bereich 1 die Spannung U1=I0*R1 und in den übrigen Bereichen jeweils U2=I0*R0 ab. Die lokale Heizleistung beträgt somit P1 =I0^2*R0*(1+a*DT) und P2=I0^2*R0. Hier führt die Verwendung eines Materials mit negativem Temperaturkoeffizienten a<O somit ebenfalls zu einer Reduktion der Heizleistung im Bereich 1, und zu einer unveränderten Heizleistung in den übrigen Bereichen, was ebenfalls eine Homogenisierung der Temperaturverteilung bedeutet. Je nach Regelkonzept können somit sowohl Spannungsspeisung als auch Stromspeisung vorteilhaft eingesetzt werden.

Als Materialien mit negativem Temperaturkoeffizienten des Widerstands für den Heizkörper eignen sich vorzugsweise polykristalline Halbleitermaterialien, beispielsweise Polysilizium oder Polysiliziumkarbid. Unter bestimmten Umständen kann auch einkristallines Halbleitermaterial mit einer genügend hohen Aktivierungsenergie der Dotierungsniveaus einen negativen Temperaturkoeffizienten des Widerstands aufweisen.

Der Heizkörper kann vorteilhaft aus einem dotierten Halbleiter bestehen. Diese zeigen eine Temperaturabhängigkeit der Leitfähigkeit, die proportional ist zu T^(-3/2)*exp(-Ea/2kT), wobei Ea das Akzeptorniveau bezeichnet und k die Boltzmann-Konstante ist. Indium bildet in Silizium zum Beispiel ein Akzeptorniveau von Ea = 160 meV, Thallium ein Akzeptorniveau von Ea = 246 meV. Indium- oder Thalliumdotiertes Silizium, als bevorzugte Materialien des Heizkörpers, haben somit einen negativen Temperaturkoeffizienten im Arbeitsbereich der Verdampfereinheit bis 300 °C und darüber hinaus. Ebenfalls günstige Materialien sind Aluminiumdotiertes Siliziumcarbid (SiC) mit Ea = 190 meV oder Bor-dotiertes Silizium-Carbid mit Ea = 285 meV.

NTC-Materialien haben im Allgemeinen einen höheren Temperaturkoeffizienten im Vergleich zu Metallen, daher ist eine deutlich genauere Bestimmung der Temperatur über die Messung des Widerstands des Heizkörpers möglich. Der Heizkörper wird vorzugsweise als elektrischer Widerstandsheizer ausgebildet.

Wie weiter oben schon angedeutet, ist erfindungsgemäß bevorzugt vorgesehen, dass als Halbleitermaterial im Wesentlichen ein Silizium verwendet wird, vorzugsweise ein Polysilizium verwendet wird, wobei vorzugsweise das Halbleitermaterial durch Dotierung wenigstens bereichsweise in seiner elektrischen Leitfähigkeit verbessert ist. Weiter kann erfindungsgemäß bevorzugt vorgesehen sein, dass das Halbleitermaterial n-dotiert ist, vorzugsweise unter Verwendung von Phosphor, wobei alternativ auch eine p-Dotierung, zum Beispiel mit Bor in Betracht kommen kann.

Das erfindungsgemäße Verfahren sieht vor, dass auf das Halbleitermaterial wenigstens bereichsweise, wenigstens eine Beschichtung auf wenigstens einer Seite des Halbleitermaterials aufgebracht wird.

Zudem kann eine Photoschicht, insbesondere aus einem Photolack aufgebracht werden, die durch Belichtung (Lithographie) mit Hilfe einer Maske strukturiert wird. Durch den belichteten Lack, dessen belichtete Bereiche in geeigneter und an sich bekannter Weise entfernt werden, entsteht vorzugsweise eine Ätzmaske zur Strukturierung des Halbleitermaterials durch ein geeignetes Ätzen.

Erfindungsgemäß ist vorgesehen, dass die Beschichtung metallisch ist. Dies geschieht zur Ausbildung von Heizelementen ringförmig in Abschnitten der Kanäle bzw. den Wandungen der Kanäle, wobei ringförmig nicht die Querschnittsfläche der Kanäle auf eine Kreisform beschränken soll, sondern allgemein im Sinne einer umlaufenden Form verstanden werden kann. Metallische Kontaktflächen in Kontakt mit einem zu verdampfenden Liquid können dadurch vorzugsweise vermieden werden, dass die Metallflächen ihrerseits mit einer passiven bzw. passivierten Schicht abgedeckt werden, zum Beispiel mit einem glasartigen Material. insbesondere könnte ein nichtmetallisches und temperaturstabiles Material verwendet werden, beispielsweise Siliziumdioxid, Siliziumnitrid oder Quarzglas.

Insbesondere ist aber vorzugsweise vorgesehen, dass das Halbleitermaterial mit elektrischen Kontakten versehen wird, vorzugsweise unter Nutzung einer metallischen Beschichtung, die anschließend erwünschtenfalls auf Kontaktflächen reduziert werden kann.

Das Halbleitermaterial kann wenigstens bereichsweise oxidiert werden, insbesondere kann auch daran gedacht werden, Zwischen- bzw. Trennschichten aus einem Halbleiteroxid vorzusehen.

Als eine Schicht oder Beschichtung kann bei dem erfindungsgemäßen Verfahren eine Durchflusssteuerschicht vorgesehen werden, mit sich durch die Durchflusssteuerschicht erstreckenden Durchgangsbohrungen, die mit den Kanälen kommunizieren. Besonders vorteilhaft ist dabei der Kontaktwinkel zwischen Flüssigkeit und der Innenwand einer oder jeder Durchgangsbohrung durch Anlegen einer mittels einer Spannungsquelle erzeugbaren elektrischen Spannung, bzw. eines von der elektrischen Spannung erzeugten elektrischen Feldes, veränderbar. Hierdurch ist vorteilhaft der Durchfluss durch die Durchgangsbohrungen veränderbar, insbesondere stoppbar und/oder, insbesondere durch ein Verringern oder ein Abschalten der elektrischen Spannung, freigebbar. Auf diese Weise lässt sich ein exaktes Fördern und Bemessenen einer Portion an Flüssigkeit in den Mikrokanälen sowie eine Rückflusssicherung und ein portionsgenaues und vollständiges Verdampfen realisieren. Hierbei wird vorzugsweise der Effekt der elektrischen Benetzung (electro wetting) genutzt.

Vorteilhaft ist zwischen der Durchflusssteuerschicht und dem Substrat eine Isolierschicht mit sich durch die Isolierschicht erstreckenden Durchgangsöffnungen vorgesehen. Hierdurch kann eine ungewollte Verdampfung von Flüssigkeit in dem Flüssigkeitsspeicher bzw. in der Durchflusssteuerschicht und den dortigen Durchflussbohrungen während der Verdampfung wirksam verhindert werden. Ebenso wird ein unerwünschter Wärmetransfer in den Flüssigkeitsspeicher vermieden. Mit anderen Worten lässt sich der Wärmeeintrag in das Substrat optimieren und ein unerwünschtes Erwärmen oder gar Verdampfen in dem Substrat vorgelagerter, Flüssigkeit enthaltender Abschnitte zuverlässig vermeiden.

Eine andere Weiterbildung des erfindungsgemäßen Verfahrens sieht vor, dass die Kanäle durch, vorzugsweise trockenes Ätzen in dem Halbleitermaterial ausgebildet werden. Bevorzugt wird erfindungsgemäß dafür im Wesentlichen ein Reaktives lonenätzen (ein RIE = Reactive Ion Etching, insbesondere ein DRIE = Dry Reactive Ion Etching) angewendet. Für den erfindungsgemäßen Fertigungsprozess eines Heizkörpers mit Kanälen wird ein anisotropes Ätzen bevorzugt, bei dem im Wesentlichen senkrecht von der Oberfläche in das Halbleitermaterial hineingeätzt wird.

Wie später auch noch beschrieben, kann erfindungsgemäß alternativ auch nass chemisch geätzt werden. Hierbei erfolgt eine Orientierung bevorzugt an Kristallrichtungen. Dabei könnten beispielsweise auch Kanäle erzeugt werden, die in ihrem Längsschnitt nicht rechteckig aussehen, sondern eher trapezförmig.

Insbesondere ist es auch möglich, Kanäle von ihrer Austrittseite her anders zu ätzen als von ihrer Eintrittsseite her, wobei durch die von beiden Seiten erfolgenden Eintunnelungen letztlich ein vollständig durchgängiger Kanal erstellt wird. Zum Beispiel könnte von der Austrittsseite her trocken geätzt werden und von der Austrittsseite her nass.

Bei dem RIE wird im Wesentlichen das Halbleitermaterial, das heißt vorzugsweise ein Wafer, in eine Prozesskammer gegeben, und zwar auf eine mit Wechselspannung betriebene Elektrode, insbesondere Hochfrequenz-Elektrode. In einem in die Prozesskammer zusätzlich eingegebenen Gas wird durch Stoßionisation ein Plasma erzeugt, das freie Elektroden und geladene Ionen enthält. Die Elektroden können mit positiven Spannungshalbwellen beschickt werden, wodurch sich die negativ geladenen, leichten Elektronen an der positiven Elektrode anlagern, die sich dadurch mit einer hohen negativen Vorspannung auflädt, da die Elektronen die Elektrode aufgrund von dazu notwendiger Austrittsarbeit nicht mehr verlassen können. Positiv geladene Ionen, die schwerer sind und den Hochfrequenzhalbwellen nicht folgen können, bewegen sich sodann auf die so negativ aufgeladene Elektrode zu, der das Halbleitermaterial zugeordnet ist. Dadurch ätzen die Ionen das Halbleitermaterial, indem sie Halbleitermaterial abtragen, was als physikalisches Ätzen bezeichnet wird. Zudem kann es zu einem chemischen Ätzen kommen, bei dem freie Radikale mit Material reagieren. Durch den Gasdruck kann die freie Weglänge der Ionen eingestellt werden, wobei eine längere Wegstrecke zu einem anisotropen Ätzen führt, da sich die Ionen auf einer längeren Wegstrecke in senkrechter Richtung zur Halbleiteroberfläche bewegen können. Der Prozessgasdruck kann zum Beispiel zwischen 1 und 100 Pa betragen, wobei für ein anisotropes Ätzen bevorzugt beispielsweise ein Gasdruck von etwa 4 bis 8 Pa, bevorzugt etwa 6 Pa vorgesehen sein kann.

Eine nächste Weiterbildung des erfindungsgemäßen Verfahrens zeichnet sich dadurch aus, dass die Kanäle von beiden Seite des Halbleitermaterials ausgehenden fluidzugänglich ausgebildet werden. Ein Durchätzen durch die gesamte Dicke des Halbleitermaterials könnte auch von nur einer Oberfläche her geschehen. Es könnte aber ein Ätzen der Kanäle insbesondere auch von einander entgegengesetzten Oberflächen geschehen, wobei dies beispielsweise auch mit unterschiedlichen Querschnittsgrößen oder Durchmessern von den beiden Seiten geschehen kann, so dass der jeweilige Kanal in seinem Verlauf unterschiedliche Durchmesser aufweist, zum Beispiel abschnittsweise gestuft oder konisch. Dies kann die gerichtete Flüssigkeitsführung und / oder deren Portionierung begünstigen.

Vorzugsweise werden die Kanäle so dünn ausgebildet, dass mit der zu verwendenden Flüssigkeit Kapillarkräfte zur Förderung der Flüssigkeit durch die Kanäle auftreten. Bevorzugt handelt es sich um Mikrokanäle und vorzugsweise erfindungsgemäß um die Fertigung eines Mikro-Elektro-Mechanisches Systems (MEMS).

Vorzugsweise ist demnach der Heizkörper so ausgebildet, dass Flüssigkeit aufgrund von Kapillarkräften in den Kanälen nachförderbar ist. In einem erfindungsgemäßen Verfahren zum zyklischen Betrieb einer Verdampfereinheit wird ausgehend von einem stabilen Gleichgewichtszustand zunächst Flüssigkeit verdampft. In einer nachfolgenden Nachfüllphase strömt Flüssigkeit mittels Kapillarkräften nach, um die verdampfte Flüssigkeit zu ersetzen, bis der Ausgangszustand wieder erreicht ist. Die Steuerung eines zeitlichen Verlaufs der Heizspannung kann an diesen zyklischen Betrieb angepasst werden. Beispielsweise kann die Heizspannung so gepulst sein, dass in der Nachfüllphase keine Heizspannung an dem Heizelement anliegt, um eine Überhitzung des Heizelements in der Nachfüllphase zu vermeiden.

Im Hinblick auf das Ziel einer möglichst homogenen Temperaturverteilung ist der Heizkörper vorteilhaft so zu gestalten, dass in Bereichen mit höherem Wärmeabtransport zur Kompensation eine höhere Wärmeleistung eingebracht wird. Dies kann beispielsweise mittels gezielt in den Heizkörper eingebrachter Verjüngungen und/oder Verbreiterungen realisiert werden.

Vorzugsweise sind Frequenz und/oder Tastgrad einer Heizspannung Uh für den Heizkörper an die Eigenschwingung und/oder Eigenfrequenz von Schwingungen von in den Mikrokanälen entstehenden Gasblasen anzupassen. Dem liegt die Erkenntnis zugrunde, dass einer Verdampfung mit passiver kapillarer Liquidzufuhr, wie zum Beispiel mittels einer Dochtstruktur, anderen Gesetzmäßigkeiten unterliegt als eine Verdampfung mit aktiver, zum Beispiel portionierter oder gepumpter Zuführung des Liquids. Zur Optimierung der Verdampfung im Sinne einer gleichmäßigen, schadstofffreien Dampferzeugung, welche unter anderem abhängig ist von der Förderrate des Liquids zu dem Heizkörper, wird die Heizspannung für den Heizkörper vorteilhaft derart gepulst angesteuert, dass die Förderrate an die Eigenschwingung der Blasenentstehung während des Blasensiedens in den Mikrokanälen angepasst ist.

Eine solche Vorbereitung des Heizkörpers kann oder muss zum Teil auch schon bei seinem Fertigungsverfahren berücksichtigt werden, indem eine bestimmte Auslegung eines Heizkörpers als Fertigungsziel vorgegeben wird.

Es hat sich gezeigt, dass eine bevorzugte Heizfrequenz im Bereich zwischen 20 Hz und 200 Hz, vorzugsweise im Bereich zwischen 25 Hz und 100 Hz, noch weiter vorzugsweise im Bereich zwischen 30 Hz und 70 Hz und beispielsweise 50 Hz einen großen Teil der in Frage kommenden Flüssigkeiten und -gemische abdeckt.

Ebenfalls bevorzugt beträgt der durch die Heizspannung Uh für den Heizkörper erzeugte maximale Heizstrom nicht mehr als 7 A, um konzentrierten Dampf bei Vermeidung von Überhitzung zu gewährleisten.

Erfindungsgemäß wird der Heizkörper mit einer Mehrzahl von Mikrokanälen versehen, die eine Einlassseite des Heizkörpers mit einer Auslassseite flüssigkeitsleitend verbinden. Die Einlassseite ist vorzugsweise über eine Dochtstruktur flüssigkeitsleitend mit einem Flüssigkeitsspeicher verbindbar. Eine Dochtstruktur, die auch schon bei der Fertigung des Heizkörpers an diesen angebracht, angeformt oder in sonstiger geeigneter Weise mit diesem verbunden werden kann, kann zur passiven Förderung von Flüssigkeit aus einem Flüssigkeitsspeicher zu dem Heizkörper mittels Kapillarkräften dienen.

Dabei kann als ein "Docht" oder eine "Dochtstruktur" jede kapillar geeignete Form eines porösen Aufbaues verstanden und verwendet werden, beispielsweise poröse Pads oder Vliese. Auch ein An- oder Aufwachsen von porösen Nanostrukturen, insbesondere direkt auf eine Einlassseite des Heizkörpers, ist denkbar.

Der mittlere Durchmesser der Mikrokanäle liegt vorzugsweise im Bereich zwischen 5 µm und 200 µm, weiter vorzugsweise im Bereich zwischen 30 µm und 150 µm, noch weiter vorzugsweise im Bereich zwischen 50 µm und 100 µm. Aufgrund dieser Abmessungen wird vorteilhaft eine Kapillarwirkung erzeugt, so dass an der Einlassseite des Heizkörpers in einen Mikrokanal eindringende Flüssigkeit durch den Mikrokanal nach oben steigt, bis der Mikrokanal mit Flüssigkeit gefüllt ist. Das Volumenverhältnis von Mikrokanälen zu Heizkörper, das als Porosität des Heizkörpers bezeichnet werden kann, liegt beispielsweise im Bereich zwischen 10% und 50%, vorteilhaft im Bereich zwischen 15% und 40%, noch weiter vorteilhaft im Bereich zwischen 20% und 30%, und beträgt beispielsweise 25%. Die Kantenlängen der mit Mikrokanälen versehenen Flächen des Heizkörpers liegen beispielsweise im Bereich zwischen 0,5 mm und 3 mm. Die Abmessungen der mit Mikrokanälen versehenen Flächen des Heizkörpers können beispielsweise betragen: 0,95 mm x 1,75 mm oder 1,9 mm x 1,75 mm oder 1,9 mm x 0,75 mm. Die Kantenlängen des Heizkörpers können beispielsweise im Bereich zwischen 0,5 mm und 5 mm liegen, vorzugsweise im Bereich zwischen 0,75 mm und 4 mm, weiter vorzugsweise im Bereich zwischen 1 mm und 3 mm liegen. Die Fläche des Heizkörpers (chip size) kann beispielsweise 1 mm x 3 mm oder 2 mm x 3 mm oder 1 mm x 2 mm betragen. Die Breite des Heizkörpers liegt vorzugsweise im Bereich zwischen 1 mm und 5 mm, weiter vorzugsweise im Bereich zwischen 2 mm und 4 mm, und beträgt beispielsweise 3 mm. Die Höhe des Heizkörpers liegt vorzugsweise im Bereich zwischen 0,05 mm und 1 mm, weiter vorzugsweise im Bereich zwischen 0,1 mm und 0,75 mm, noch weiter vorzugsweise im Bereich zwischen 0,2 mm und 0,5 mm und beträgt beispielsweise 0,3 mm.

Die Anzahl der Mikrokanäle liegt vorzugsweise im Bereich zwischen vier und 1000. Auf diese Weise lässt sich der Wärmeeintrag von dem Substrat in die Mikrokanäle optimieren und eine gesicherte hohe Verdampfungsleistung sowie eine ausreichend große Dampfaustrittsfläche realisieren.

Die Mikrokanäle können in Form eines quadratischen, rechteckigen, vieleckigen, runden, ovalen oder anders geformten Arrays angeordnet sein. Das Array kann in Form einer Matrix mit s Spalten und z Zeilen ausgebildet sein, wobei s vorteilhaft im Bereich zwischen 2 und 50 und weiter vorteilhaft im Bereich zwischen 3 und 30 und/oder z vorteilhaft im Bereich zwischen 2 und 50 und weiter vorteilhaft im Bereich zwischen 3 und 30 liegt. Auf diese Weise lässt sich eine effektive und auf einfache Weise herstellbare Anordnung der Mikrokanäle mit gesichert hoher Verdampfungsleistung realisieren.

Der Querschnitt der Mikrokanäle kann quadratisch, rechteckig, vieleckig, rund, oval oder anders geformt sein, und/oder sich in Längsrichtung abschnittweise ändern, insbesondere vergrößern, verkleinern oder konstant bleiben.

Die Länge eines oder jedes Mikrokanals liegt vorzugsweise im Bereich zwischen 100 µm und 1000 µm, weiter vorzugsweise im Bereich zwischen 150 µm und 750 µm, noch weiter vorzugsweise im Bereich zwischen 180 µm und 400 µm und beträgt beispielsweise 300 µm. Auf diese Weise lässt sich eine optimale Flüssigkeits-aufnahme und Portionsbildung bei ausreichend gutem Wärmeeintrag von dem Heizkörper in die Mikrokanäle realisieren.

Der Abstand zweier Mikrokanäle beträgt vorzugsweise mindestens das 1,3-fache des lichten Durchmessers eines Mikrokanals, wobei der Abstand auf die Mittelachsen zweier einander benachbarter Mikrokanäle bezogen ist. Der Abstand kann bevorzugt das 1,5- bis 5-fache, weiter bevorzugt das 2- bis 4-fache des lichten Durch-messers eines Mikrokanals betragen. Auf diese Weise lässt sich ein optimaler Wärmeeintrag von dem Substrat in die Mikrokanäle und eine ausreichend stabile Anordnung und Wandstärke der Mikrokanäle realisieren.

Aufgrund der vorbeschriebenen Merkmale kann der Heizkörper auch als Volumenheizer bezeichnet werden.

Wie zuvor schon mehrfach angedeutet, ist bei dem erfindungsgemäßen Verfahren vorzugsweise vorgesehen, dass eine Mehrzahl von Heizelementen auf einem Wafer ausgebildet wird und vorzugsweise anschließend einzelne Heizkörper oder Gruppen von Heizkörpern aus dem Wafer, vorzugsweise als sogenannte Dies, entnommen werden.

Jeder Heizkörper hat dabei bevorzugt die Dicke eines Wafers, was gleichzeitig der Länge seiner durchgängigen Kanäle entspricht. Die Durchmesser eines Wafers können bekanntlich bevorzugt etwa in einem Bereich von einschließlich etwa 100 mm bis einschließlich etwa 450 mm betragen, mit einer Tendenz zu noch größeren Wafern. Je größer der Wafer ist, desto mehr Heizkörper können mit ihm erstellt werden und desto kleiner ist jedenfalls prinzipiell der Stückpreis eines Heizkörpers, was durchaus eine relevante wirtschaftliche Größe ist, da ein Heizkörper oder auch eine Gruppe von Heizkörpern vorzugsweise in einem geschlossenen Tanksystem in einer Kartusche bereitgestellt werden soll und die nach Verbrauch der Substanz entsorgt wird. Die für den Heizkörper erfindungsgemäß verwendeten Materialien haben dabei somit auch den Vorteil, dass sie umweltverträglich entsorgt und ggfls. auch recycelt werden können.

Der Heizkörper kann vorteilhaft aus Teilstücken eines Wafers mit Dünnfilmschichttechnologie hergestellt werden, welcher eine Schichtdicke von vorzugsweise kleiner oder gleich 1000 µm, weiter vorzugsweise 750 µm, noch weiter vorzugsweise kleiner oder gleich 500 µm aufweist. Oberflächen des Heizkörpers können vorteilhaft hydrophil sein. Die Auslassseite des Heizkörpers kann vorteilhaft mikrostrukturiert sein bzw. Mikroausnehmungen (micro grooves) aufweisen.

Der Wafer kann nach im Wesentlichen fertiggestellten Heizkörperbereichen so zerteilt ("gedict" von "dicing") werden, dass Bereiche ("dies") des Wafers einen oder mehrere Heizkörper aufweisen.

Üblicherweise kann ein solches dicen durch sägen, ritzen und brechen oder auch durch Laserschneiden erfolgen. Insbesondere kann dies präzise maschinengesteuert erfolgen. Bei einem DGB-Verfahren ("dice before grind") wird der Wafer entlang der dies-Grenzen halbtief geschnitten und dann an seiner geschnittenen Seite auf einem Haltetape gehalten, während der Wafer an seiner ungeschnittenen Rückseite auf seine Zielmaterialstärke abgeschliffen und gedünnt wird.

Bei einem sogenannten "stealth"-dicing werden die Grenzen eines dies zunächst mit einem Laser geschwächt und dann gebrochen. Als Laser kann insbesondere ein Nd:YAG - Laser verwendet werden, der vorzugsweise gepulst betrieben wird. Eine maximale Absorption der Laserenergie durch Fokussierung des Laserstrahls kann dadurch erfolgen, dass der Laser mit einer Wellenlänge von 1064 nm betrieben wird, um diese möglichst gut an das elektronische Bandgap von Silizium im Bereich in der Größe von 1,11 eV oder 1117 nm anzupassen. Die Pulsierung des Lasers kann zum Beispiel bei etwa 100kHz liegen und der Wafer kann zum Beispiel mit einer Geschwindigkeit von 1m/s bewegt werden, um eine, gegebenenfalls auch mehrfach abzufahrende Schwächungslinie entlang der Grenze des dies zu erreichen. Dabei können wenige µm³ kleine Volumenbereiche des Siliziums innerhalb von Nanosekunden auf etwa 1000 K erhitzt werden.

Ein trockenes dicen, insbesondere das vorbeschriebene stealth - dicen, ist gerade für die Separierung von MEMS - Strukturen vorteilhaft, wenn nicht sogar unabdingbar. Insbesondere ist es auch bei der erfindungsgemäßen Bereitstellung eines im Prinzip gelochten Heizkörpers vorteilhaft, da durch die in den Heizkörper eingebrachten Kanäle (oder Löcher) das Halbleitermaterial, das ohnehin spröde sein kann, in gewisser Weise geschwächt ist. Ein behutsames und kontrolliertes dicen ist daher empfehlenswert.

An dieser Stelle sei erwähnt, dass die Kanäle in das Halbleitermaterial gelasert werden könnten, so dass ein Ätzen weitgehend oder ganz vermieden wird. Alternativ könnten die Kanäle auch in das Halbleitermaterial in einer sonstigen geeigneten Weise gebohrt oder gestanzt oder in sonstiger Weise mechanisch eingearbeitet werden.

Eine nächste Weiterbildung des erfindungsgemäßen Verfahrens sieht vor, dass der Heizkörper oder die Heizkörper im Wesentlichen als Nacktchip (sogenannter "bare chip") weiterverwendet wird. Zwar können zum Beispiel einzelne Heizkörper oder Gruppen von Heizkörpern auch in irgendeiner Weise eingefasst, zum Beispiel gerahmt werden, um leckagefrei in ein geschlossenes Tanksystem integriert zu werden, jedoch bleibt der Heizkörper als solcher als Chip bevorzugt funktionell für die Verdampferfunktion nackt.

Für einen erfindungsgemäß gefertigten Heizkörper wird auch unabhängiger Schutz beansprucht.

Für einen Wafer aus einem Halbleitermaterial, der erfindungsgemäß eine Mehrzahl von Heizkörpern oder als Heizkörper geeignete Elemente oder Bereiche aufweist, wird, insbesondere als Halbfabrikat, ebenfalls selbständiger Schutz beansprucht.

Die Erfindung wird im Folgenden anhand bevorzugter Ausführungsformen unter Bezugnahme auf die beigefügten Figuren erläutert. Dabei zeigt
- Fig. 1: eine perspektivische Ansicht eines Ausführungs-beispiels eines nach dem erfindungsgemäßen Verfahren hergestellten Heizkörpers;
- Fig. 2 bis 6: unterschiedliche, zumindest zum Teil fakultative Phasen eines Fertigungsprozesses eines Heizkörpers gemäß Fig. 1;
- Fig. 7 bis 11: unterschiedliche Ausführungsformen von Heizelementen in einer Draufsicht von oben auf die Austrittsseite eines Heizkörpers;
- Fig. 12: eine schematische Querschnittsansicht einer Mikrofibrille für eine bionische Struktur; und
- Fig. 13: eine aus Mikrofibrillen gemäß Figur 12 aufgebaute bionische Heizstruktur,
- Fig. 14: eine perspektivische Querschnittsansicht einer erfindungsgemäßen Verdampfereinheit;
- Fig. 15: eine schematische Querschnittsansicht einer erfindungsgemäßen Verdampfereinheit;
- Fig. 16: eine perspektivische Schnittansicht einer Verdampfereinheit; und
- Fig. 17: eine schematische Darstellung eines einfachen Ausführungsbeispiels eines elektronischen Zigarettenprodukts.

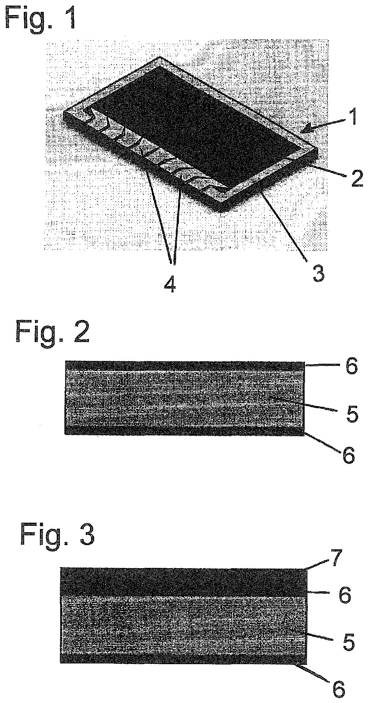

Fig. 1 zeigt eine perspektivische Ansicht eines Ausführungsbeispiels eines nach dem erfindungsgemäßen Verfahren hergestellten Heizkörpers. Gezeigt ist eine Oberfläche des Heizkörpers 1, von der Metallkontakte und Mikrokanäle des Heizkörpers 1 zugänglich sind, während die andere Oberfläche des Heizkörpers 1 nicht erkennbar ist. Die gewählte Austrittsseite der Mikrokanäle des Heizkörpers 1 kann in einem Inhalator im Wesentlichen frei liegen.

Der Heizkörper 1 liegt als ein Halbleiterchip vor, der in seinem mittleren Bereich ein Feld 2 mit einer Vielzahl von Mikrokanälen aufweist, mit denen der Heizkörper flüssigkeitsdurchlässig durchlöchert ist. Die Mikrokanäle sind in ihren Durchmessern so klein, dass sie in der Darstellung der Fig. 1 nicht mit hinreichender Auflösung erkennbar sind. Im Randbereich 3 des Heizkörpers 1 sind elektrische Kontakte 4 zu erkennen, die aus einer strukturierten Metallschicht gebildet worden sind. Diese Kontakte 4 könnten beispielsweise als Steckerleiste in eine Steckeraufnahme einer anderen elektrischen Einrichtung, insbesondere einer Steuereinrichtung eines Inhalators, zur elektrischen Verbindung mit dieser Einrichtung eingesteckt werden.

Die Fig. 2 bis 6 zeigen unterschiedliche, zumindest zum Teil fakultative Phasen eines Fertigungsprozesses eines Heizkörpers 1 gemäß Fig. 1. Es sind in den Fig. 2 bis 6 jeweils prinzipielle Schnitte durch einen Abschnitt eines Wafers aus einem Halbleitermaterial, vorzugsweise aus Silizium, gezeigt, die den Aufbau von Schichten des Wafers jeweils in den unterschiedlichen Phasen erkennen lassen.

In Fig. 2 ist zunächst das grundsätzliche Halbleitermaterial 5 zu erkennen. In der in Fig. 2 dargestellten ersten Phase ist aber auf dieses Halbleitermaterial 5 jeweils auf der Oberseite und der Unterseite mindestens eine Isolierschicht 6 aufgebracht. Diese Isolierschicht bzw. Isolierschichten 6 können zum Beispiel aus Siliziumnitrid und/oder Siliziumoxinitrid gebildet sein.

Siliziumnitrid (Si3N4) ist ein amorphes Halbleitermaterial. Es hat gegenüber anderen Halbleitern den Vorteil, dass es nichtleitend ist und bei "Lecks" in der Siliziumnitrid-Schicht keine Ladungsträger abfließen.

Eine andere oder weitere Isolierschicht 6 könnte aus thermischem Oxid gebildet sein.

Siliziumnitrid könnte insbesondere per LPCVD-Prozess (Low Pressure Chemical Vapor Deposition oder Chemische Gasabscheidung) bei Unterdruck aufgebracht werden und beispielsweise bei einer Prozesstemperatur von etwa 900° C, beispielsweise in einer Schichtdicke von etwa 100 nm. Thermisches Oxid könnte zum Beispiel mit einer Schichtdicke von etwa 400 nm erstellt werden.

In Fig. 3 ist die zweite Phase dargestellt, in der auf den Wafer eine Schicht Polysilizium 7 auf den Wafer aufgebracht wird. Dies könnte wiederum mit einem LPCVD-Prozess geschehen. Das Polysilizium könnte auch gleich (in-situ) dotiert werden, vorzugsweise n-dotiert werden, bevorzugt mit Phosphor. Die Prozesstemperatur könnte zum Beispiel etwa 580° C betragen. Die Schichtdicke des Polysiliziums könnte beispielsweise etwa 2µm betragen, aber auch vorzugsweise durchaus größer sein. Der spezifische elektrische Widerstand könnte zum Beispiel etwa 7,5 X 10^-6 Ohm x Meter (oder vorzugsweise auch weniger) betragen. Danach kann ein Ausheizvorgang unter vorzugsweise Nitrogen-Atmosphäre bei zum Beispiel etwa 1050° C und für zum Beispiel 30 min erfolgen.

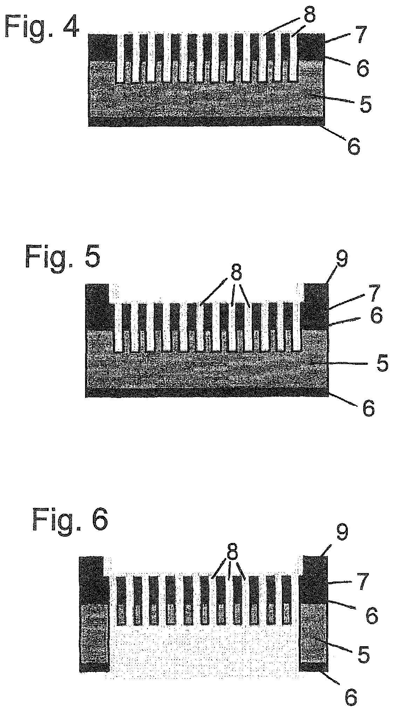

Fig. 4 zeigt die dritte Phase eines möglichen, erfindungsgemäßen Fertigungsverfahrens. Mittels einer ersten Maske und vorzugsweise mit einem Photolack wird eine Lithographie des Wafers durchgeführt, bei der von der Oberseite des Wafers Mikrokanäle 8 in den Wafer eingeätzt werden, die zunächst nur ein Stück weit in den Wafer im Wesentlichen senkrecht hinabreichen. Insbesondere könnten die Mikrokanäle 8 in diesem ersten Ätzschritt (jeweils soweit vorhanden) durch die Polysiliziumschicht, die Siliziumnitridschicht, die thermische Oxidschicht und etwa 2 bis 20 µm tief in das Silizium hinein eingebracht werden. An ihren unteren Enden sind die Mikrokanäle 8 noch durch die restliche Siliziumschichtdicke und die unteren Isolationsschichten 6 verschlossen. Die Mikrokanäle 8 werden im Wafer jeweils in den Bereichen eingebracht, in denen Heizkörper 1 ausgebildet werden sollen. Das Ätzen geschieht vorzugsweise als Trockenätzen, bevorzugt als reaktives lonenätzen (RIE). Optional könnte eine Oxidation als Ätzstopp und zur Passivierung vorgenommen werden.

In Fig. 5 wird eine nächste optionale Phase im Fertigungsprozess gezeigt, in der mittels einer zweiten Maske und einer zweiten Lithographie selektiv elektrische Kontakte 9 auf den Wafer aufgebracht werden, zum Beispiel aus Aluminium, vorzugsweise durch "Sputtern". Danach könnte eine weitere Ausheizung bei zum Beispiel etwa 450° C für beispielsweise 30 min erfolgen.

An dieser Stelle soll erwähnt werden, dass die Phasen gemäß den Fig. 4 und 5 im Wesentlichen auch in umgekehrter zeitlicher Abfolge durchgeführt werden könnten. Es könnten also zunächst elektrische Kontakte 9 auf die Polysiliziumschicht 7 aufgebracht werden, bevor die Mikrokanäle 8 in den Wafer hineingeätzt werden. Die elektrischen Kontakte könnten statt durch Sputtern auch durch Plattieren aufgebracht werden, also zum Beispiel durch chemische Metallabscheidung aufgebracht werden. Es kommen dafür auch zum Beispiel Chrom und/oder Gold und/oder eine Legierung daraus in Betracht. Insbesondere können widerstandsarme, leicht lötbare Kontakte in Betracht kommen. Elektrische Kontakte könnten zum Beispiel mit einer Schichtdicke von etwa 500 nm aufgebracht werden.

In Fig. 6 ist eine weitere Phase der Fertigung gezeigt. Zunächst könnte auf die Kontakte 9 ein Schutz aufgebracht werden. Im Wesentlichen wird aber der Wafer nun von der Rückseite bzw. Unterseite bearbeitet, indem mit einer dritten Maske von dieser Seite her eine erneute Lithographie erfolgt, um das Restmaterial des Siliziums 5 zu entfernen, pro Heizkörper 1 zum Beispiel mittels einer großen zentralen Öffnung, und so die Mikrokanäle 8 an ihren bisher geschlossenen Enden für eine Flüssigkeitsdurchlässigkeit zu öffnen. Wie bereits weiter oben erwähnt, könnten die Mikrokanalenden dabei auch einen anderen Querschnitt erhalten als die Öffnungen der Mikrokanäle 8 an der Oberseite des Wafers. Der Austrag des Materials geschieht wieder vorzugsweise durch Ätzen, insbesondere durch RIE und/oder DRIE. Dabei kann DRIE bevorzugt für das Siliziummaterial bzw. das sonstige ursprüngliche Wafermaterial verwendet werden, während RIE bevorzugt für das Durchstoßen einer Oxidschicht verwendet wird, falls eine solche zuvor als Ätzstopp aufgebracht worden war.

Als nächstes (in der Zeichnung nicht näher dargestellt) können aus dem Wafer einzelne Heizkörper 1 oder Heizkörpergruppen herausgetrennt werden ("dicing"). Der Schutz der Kontakte 9, falls zuvor angebracht, kann wieder entfernt werden.

Im Prinzip sind die Heizkörper damit fertiggestellt und funktionsfähig. Flüssigkeit bzw. Liquid kann durch die Mikrokanäle 8 aus einem Reservoir von einer Eintrittsseite der Mikrokanäle 8 zu einer Austrittseite hindurch gefördert werden und dabei durch elektrische Widerstandsheizung des gedopten Halbleitermaterials des Heizkörpers 1 erhitzt und zu einer Aerosolbildung verdampft werden. Dabei können die Mikrokanäle 8 bevorzugt kapillar wirken, aber es käme auch eine geeignete Art einer Pumpförderung in Betracht. Bei kapillaren Mikrokanälen 8 könnten diese im Prinzip direkt auf eine Flüssigkeitsoberfläche eines Reservoirs aufgebracht werden. Es kommt aber auch der Einsatz von Vliesen, Dochten, porösen Materialien oder dergleichen zur Flüssigkeitsförderung, insbesondere in einem Schnittstellenbereich, in Betracht. Dies ist für eine gleichmäßige Verteilung und Erwärmung der Flüssigkeit über den Heizkörper 1 zumeist sogar zu bevorzugen. In jedem Falle soll und kann für eine leckagedichte Flüssigkeitsförderung gesorgt werden.

Obwohl der so erfindungsgemäß hergestellte Heizkörper "nackt" verwendet werden kann, ist es natürlich auch möglich, ihn in geeigneter Weise zu verpacken, beispielsweise ihn mit einer Polyimidschicht zu verbinden, ohne die Flüssigkeitsförderung zu beeinträchtigen oder die Leckagedichtheit zu gefährden.

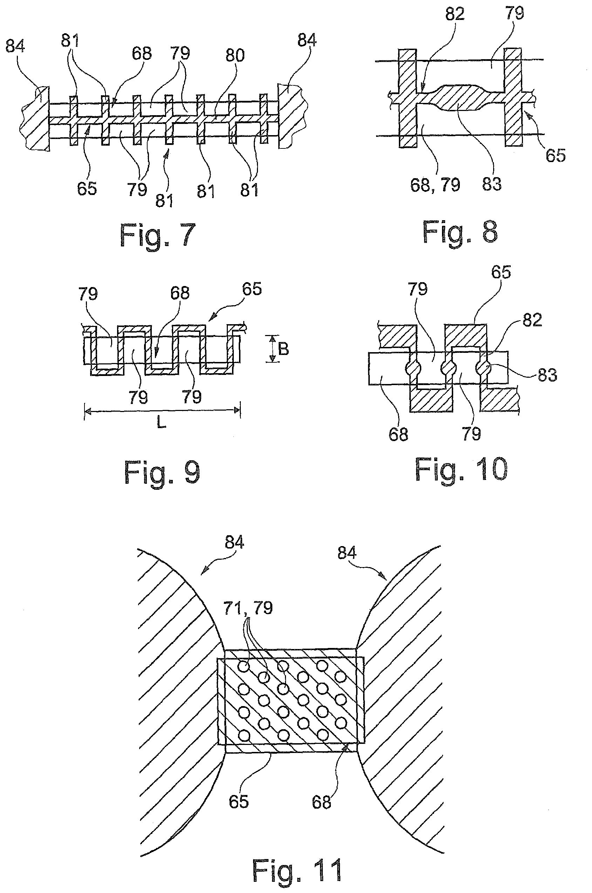

Wie aus den Figuren 7 bis 11 und insbesondere Figur 9 ersichtlich ist, kann die Austrittsöffnung 68 eines Heizkörpers, anders als in den vorhergehenden Figuren, vorteilhaft auch länglich bzw. schlitzförmig ausgebildet sein, d.h. die Länge L der Öffnung 68 kann vorzugsweise um mindestens einen Faktor 1.5, weiter vorzugsweise um mindestens einen Faktor 2, noch weiter vorzugsweise um mindestens einen Faktor 2.5 größer als deren Breite B sein. Die Öffnung 68 kann auch anders geformt sein, beispielsweise rund, quadratisch oder vieleckig.

Das hier beispielhaft gezeigte Heizelement 65 eines Heizkörpers besteht vorzugsweise aus einem NTC-Material mit negativem Temperaturkoeffizienten. In der elektronischen Einheit 19 ist vorzugsweise eine Einrichtung 72 zur Messung des Widerstands des Heizelements 65 vorgesehen. Die elektronische Einheit 19 kann vorteilhaft eine Temperatursteuerung oder -regelung des Heizelements 65 auf der Grundlage der mittels der Widerstandsmesseinrichtung 72, oder eines nicht gezeigten T-Sensors oder eines Nachbarheizelements, durchführen.

Als Material für den Heizkörper dient vorzugweise wiederum ein Siliziumsubstrat von beispielsweise ca. 0,3 mm bis 1 mm Dicke. Die hier den Kanal 62 bildende Öffnung 68 im Siliziumsubstrat kann bei Verwendung von 100-Wafern zum Beispiel durch nasschemisches Ätzen mit Kaliumhydroxidlösung (KOH) so gestaltet werden, dass sie vorteilhaft konisch zuläuft. Dies führt zu einem geringen Nachströmwiderstand und somit einer großen freisetzbaren Dampfmenge. Wie schon früher erläutert, kann dieses Nassätzen bevorzugt von einer Einlassseite des Heizkörpers her vorgenommen werden, während beispielsweise von der Auslassseite her eine Trockenätzen bevorzugt und vorgenommen werden könnte.

Um die Chipabmessungen gering zu halten, kann es jedoch auch vorteilhaft sein, eine Öffnung mit senkrechten Wänden zu erzeugen, bei der der Querschnitt des Kanals 62 von der Eintrittsseite 61 zur Austrittsseite 64 konstant bleibt. Dies könnte durch Trockenätzen oder KOH-Ätzen von 110-Wafern erreicht werden.

Das Heizelement 65 besteht vorzugsweise aus einer 0,5 µm bis 10 µm dicken Schicht aus einem geeigneten, elektrisch leitenden Material. Das grundständige Halbleitermaterial und das Heizelement 65 können durch eine thermisch und/oder elektrisch isolierende Schicht 74 voneinander getrennt sein. Dies entspräche den Schichten 7, 5 und 6 in den Fig. 2 bis 6.

Der Kapillareffekt kann vorteilhaft durch eine in dem Liquid-Kanal 62 vorgesehene Förder- und/oder Durchflusssteuereinrichtung unterstützt werden. Dabei kann es sich insbesondere um eine Pumpe, ein Ventil und/oder eine auf elektrischer Benetzung (electro wetting) beruhende Einrichtung handeln.

Die Zyklusdauer eines Verdampfungszyklus kann vorzugsweise im Bereich zwischen 20 ms und 200 ms liegen, sodass der Nutzer den Dampf als ungepulst empfindet und eine entsprechende Anzahl von Zyklen pro Rauchvorgang bzw. pro Zug abgeschlossen werden können. Alternativ könnte die Verdampfungssteuerung auch so ausgelegt werden, dass ein einziger Zyklus von beispielsweise ca. 2 s Dauer als Rauchvorgang bzw. Puff oder Zug verwendet wird. Im allgemeinen ist die Heizspannung Uh vorzugsweise gepulst mit einer Pulsfrequenz im Bereich zwischen 10 Hz und 10 kHz.

Die lichte Austrittsweite, begrenzt durch das bzw. ein Heizelement 65, weist vorteilhaft Abmessungen zwischen ca. 10 µm und 500 µm auf, um ein Auslaufen eines Liquids über eine genügend hohe Kapillarkraft zu verhindern.

Die Solltemperatur für die Verdampfung der Liquide liegt allgemein im Bereich zwischen 100 °C und 400 °C.

Der Heizkörper ist vorzugsweise ein mikro-elektromechanisches (MEMS) Bauteil, wird vorzugsweise in Reinraum- Technologie gefertigt und weist eine definierte Geometrie der Öffnung 68 und des Heizelementes 65 auf.

Die Geometrie des Heizelements 65 ist vorteilhaft so ausgelegt, dass sich eine homogene Temperaturverteilung über das Heizelement 65 ergibt. Zu diesem Zweck kann der lokale Querschnitt des Heizelements 65 so variiert werden, dass an Stellen erhöhter Wärmeverluste eine erhöhte Heizleistung, insbesondere durch lokale Reduzierung des elektrischen Widerstands, eingestellt wird.

Verschiedene nicht erfinderische Formen des Heizelements 65 sind in den Figuren 7 bis 11 jeweils in einer Draufsicht von oben gezeigt.

In der Ausführungsform nach Figur 7 wird das schraffiert dargestellte Heizelement 65 so in Längsrichtung über die schlitzförmige Öffnung 68 angeordnet, dass ein länglicher, parallel zur Längsrichtung der Öffnung 68 ausgerichteter zentraler Steg 80 gebildet ist. Der Steg 80 ist über eine Mehrzahl von seitlichen Fortsätzen 81, die über die Länge des Stegs 80 verteilt sind, beidseitig entlang der Längsseiten des Schlitzes 68 an dem Heizkörper mit dem Rand der Öffnung 68 verbunden. Auf diese Weise ist eine Mehrzahl von Düsen 79 gebildet, wobei jeweils eine Düse 79 von dem Steg 80, zwei Fortsätzen 81 und einem Teil der Öffnungskante der Öffnung 68 gebildet ist. Die Öffnungsweite einer Düse 79 liegt im Bereich von ca. 10 µm bis 0,2 mm. Die Breite des Stegs 80 und der Fortsätze 81 hängen kritisch vom Material des Heizelements 65 ab. Sie liegen vorteilhaft im Bereich zwischen ca. 5 µm und 0,1 mm.

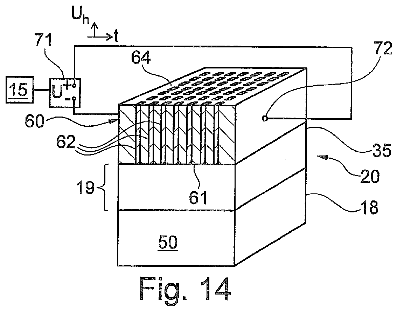

Die Düsen 79 könnten auch allein als Kanäle 62 angesehen werden und diesen, insbesondere alternativ zu den Darstellungen in den Fig. 14 bis 16, entsprechen. Überhaupt könnte eine andere Weiterbildung des erfindungsgemäßen Heizkörpers vorsehen, dass sich eine Anzahl K1 von Durchflusskanälen, eine Anzahl K2 von Durchgangsöffnungen und/oder eine Anzahl K3 von Durchgangsbohrungen voneinander unterscheiden, und/oder einer Gruppe von Durchflusskanälen, insbesondere mit einer Gruppenanzahl G1 kleiner oder gleich K1, eine einzige DurchgangsÖffnung und/oder eine einzige Durchgangsbohrung zugeordnet ist, und zwar insbesondere gegebenenfalls als Eintritts- und/oder als Austrittsöffnung.

Die Durchflusskanäle, Durchgangsöffnungen und/oder Durchgangsbohrungen können gleiche oder voneinander verschiedene Durchtrittsquerschnitte aufweisen. Die Anzahl K1 der Durchflusskanäle, vorzugsweise Mikrokanäle, die Anzahl K2 der Durchgangsöffnungen und / oder die Anzahl K3 der Durchgangsbohrungen können sich voneinander unterscheiden. Insbesondere kann K1 größer sein als K2 und/oder größer sein als K3. K2 kann größer sein als K3. Einer Gruppe von Durchflusskanälen / Mikrokanälen, insbesondere mit einer Gruppenanzahl G1 kleiner oder gleich K1, kann eine einzige Durchgangsöffnung und/oder eine einzige Durchgangsbohrung zugeordnet sein, welche mit ihrem Querschnitt dem Querschnitt der Gruppe von Durchflusskanälen / Mikrokanälen angepasst ist, ihm insbesondere entspricht oder übersteigt. Auf diese Weise könnten erwünschtenfalls eine Gruppe von mehreren Kanälen mit einer geringeren Anzahl an Durchgangsöffnungen vorzugsweise wahlweise gesperrt und/oder freigegeben und eine einfachere Fertigung realisiert werden. Auf diese Weise kann eine Gruppe von mehreren Kanälen mit einer geringeren Anzahl an Durchgangsbohrungen zum Versorgen mit Flüssigkeit und einer einfacheren Fertigung realisiert werden. Es kann beispielsweise einer Gruppe mit einer Gruppenanzahl G1 von 3 bis 10 Kanälen eine gemeinsame Durchgangsöffnung und / oder eine gemeinsame Durchgangsbohrung zugeordnet sein. Die Durchgangsöffnung und/oder die Durchgangsbohrung übergreift dabei die 3 bis 10 Kanäle.

Da die Fortsätze 81 Wärme abführen, ist der Steg 80 an den Anschlussstellen zu den Fortsätzen 81 hin kühler als in der Mitte zwischen zwei Fortsätzen 81. Dieser Effekt kann durch eine Verjüngung 82 des Stegs 80 an der Anschlussstelle zum Fortsatz 81, und/oder eine Verbreiterung 83 des Stegs 80 in Längsrichtung zwischen zwei Fortsätzen 81, kompensiert werden, siehe Figur 8. Aufgrund der erhöhten Stromdichte im Bereich der Verjüngung 82 wird hier mehr Wärme erzeugt, was den erhöhten Wärmeabfluss kompensiert.

Eine weitere vorteilhafte Ausführungsform, bei der das Heizelement 65 als Mäander geformt ist, ist in Figur 9 dargestellt. Der erhöhte Wärmeabfluss an den Verbindungsstellen zum Öffnungsrand der Öffnung 68 kann wie beschrieben durch Verjüngungen 82 bzw. Verbreiterungen 83 kompensiert werden, siehe Figur 10.

Eine weitere Ausführungsform ist in Figur 11 dargestellt. Eine große Öffnung 68 im Halbleitermaterial wird durch eine Schicht aus Heizmaterial abgedeckt, die das Heizelement 65 bildet. In dieser Schicht befindet sich eine Mehrzahl von Löchern 71 mit einem Durchmesser im Bereich zwischen ca. 10 µm und 0,5 mm als Düsen 79 zum Dampfaustritt.

Die Figuren 7, 11 und 13 zeigen Elektroden 84, die zum Anlegen der Heizspannung Uh an das Heizelement 65 mit diesem verbunden sind.

Das Heizelement 65 kann die Form eines Heizdrahtes oder eine andere geeignete Form haben. Die Messung des Widerstands des Heizelements 65 mittels der Messeinrichtung 72 dient zur Messung der Temperatur des Heizelements 65 und gegebenenfalls zur Regelung desselben durch Anpassung des Betriebsstroms Ih oder der Betriebsspannung Uh. Die Temperaturmessung kann über den gesamten Heizkörper erfolgen oder nur über Teilabschnitte. So kann bei Stromspeisung durch Messung der Spannung zwischen zwei Fortsätzen 81 (Figur 7) oder zwischen zwei Windungen des Mäander (Figur 9) der lokale Widerstand und somit die lokale Temperatur gemessen werden.

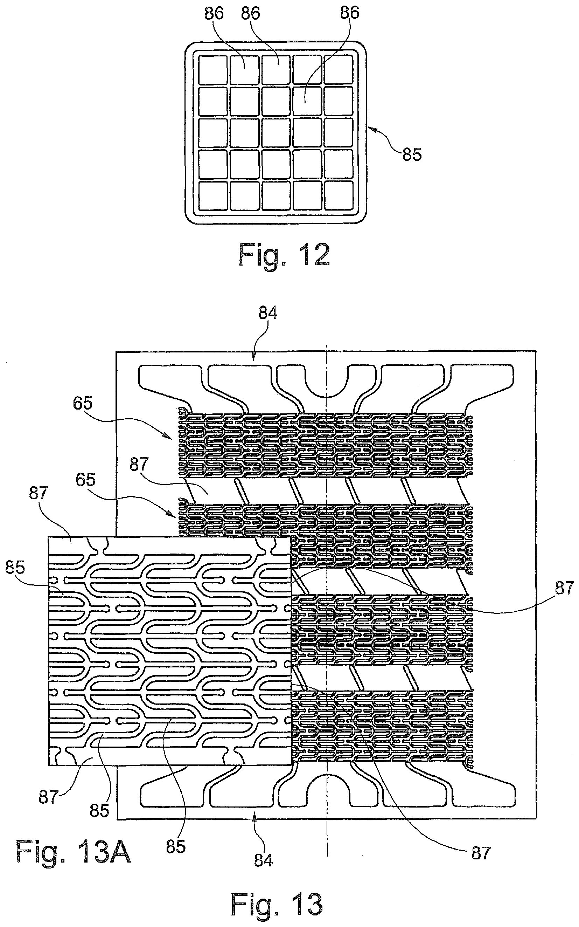

Alternative Ausführungen der Heizelemente 65 sind in den Figuren 12 und 13 gezeigt. Deren Form mit Heizleitern 85 ist an bionische Strukturen, wie sie in Form von Mikrofibrillen insbesondere in Holzfaserzellen oder Tracheen zu finden sind, angelehnt, siehe Figur 12. Vorteilhafte Abmessungen der Kanäle 86 zwischen den Heizleitern 85, d.h. der freie Abstand zwischen benachbarten Heizstrukturen 85, liegen im Bereich zwischen 10 µm und 0.5 mm, weiter vorteilhaft zwischen 15 µm und 150 µm.

Eine bionische Heizstruktur mit entsprechend geformten und beabstandeten Heizelementen 65, die durch Leitungsabschnitte 87 seriell miteinander verbunden sein können, ist in Figur 13 gezeigt. Die Figur 13A ist eine vergrößerte auszugsweise Darstellung der Figur 13 im Bereich eines Heizelements 65. Wie in den Figuren 13 und 13A erkennbar ist, ergibt sich durch die vorteilhafte netzartige Verknüpfung der Heizelemente 85 bzw. der Heizelementgeometrie eine dichte Flächenstruktur mit großer Flächenabdeckung, was eine besonders schnelle und effiziente Verdampfung von Flüssigkeit ermöglicht.

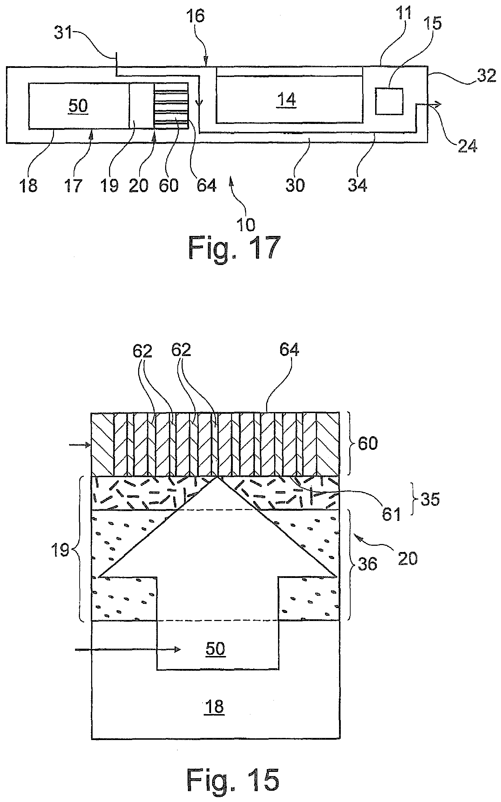

Andere vorteilhafte Ausführungsformen einer erfindungsgemäßen Verdampfereinheit 20 sind in den Fig. 14 und 15 in unterschiedlichen Querschnitten gezeigt. Die Verdampfereinheit 20 umfasst einen blockförmigen, vorzugsweise monolithischen Heizkörper 60 aus einem Halbleitermaterial, vorzugsweise Silizium. Es ist nicht erforderlich, dass der gesamte Heizkörper 60 aus einem elektrisch leitenden Material besteht. Erfindungsgemäß ist die Oberfläche des Heizkörpers 60 metallisch beschichtet. Es muss nicht die gesamte Oberfläche beschichtet sein, beispielsweise können metallische Leiterbahnen auf einem halbleitenden Grundkörper vorgesehen sein. Es ist auch nicht zwingend erforderlich, dass der gesamte Heizkörper 60 heizt; es kann beispielsweise ausreichen, wenn ein Abschnitt oder eine Heizschicht des Heizkörpers 60 im Bereich der Austrittsseite 64 heizt.

Der Heizkörper 60 ist mit einer Mehrzahl von Mikrokanälen 62 versehen, die eine Einlassseite 61 des Heizkörpers 60 mit einer Auslassseite 64 flüssigkeitsleitend verbinden. Die Einlassseite 61 ist über eine Dochtstruktur 19 flüssigkeitsleitend mit dem Flüssigkeitsspeicher 18 verbunden. Die Dochtstruktur 19 dient zur passiven Förderung von Flüssigkeit aus einem Flüssigkeitsspeicher 50 zu dem Heizkörper 60 mittels Kapillarkräften.

Der mittlere Durchmesser der Mikrokanäle 62 liegt vorzugsweise im Bereich zwischen 5 µm und 200 µm, weiter vorzugsweise im Bereich zwischen 30 µm und 150 µm, noch weiter vorzugsweise im Bereich zwischen 50 µm und 100 µm. Aufgrund dieser Abmessungen wird vorteilhaft eine Kapillarwirkung erzeugt, so dass an der Einlassseite 61 in einen Mikrokanal 62 eindringende Flüssigkeit durch den Mikrokanal 62 nach oben steigt, bis der Mikrokanal 62 mit Flüssigkeit gefüllt ist. Das Volumenverhältnis von Mikrokanälen 62 zu Heizkörper 60, das als Porosität des Heizkörpers 60 bezeichnet werden kann, liegt beispielsweise im Bereich zwischen 10% und 50%, vorteilhaft im Bereich zwischen 15% und 40%, noch weiter vorteilhaft im Bereich zwischen 20% und 30%, und beträgt beispielsweise 25%. Die Kantenlängen der mit Mikrokanälen 62 versehenen Flächen des Heizkörpers 60 liegen beispielsweise im Bereich zwischen 0,5 mm und 3 mm. Die Abmessungen der mit Mikrokanälen 62 versehenen Flächen des Heizkörpers 60 können beispielsweise betragen: 0,95 mm x 1,75 mm oder 1,9 mm x 1,75 mm oder 1,9 mm x 0,75 mm. Die Kantenlängen des Heizkörpers 60 können beispielsweise im Bereich zwischen 0,5 mm und 5 mm liegen, vorzugsweise im Bereich zwischen 0,75 mm und 4 mm, weiter vorzugsweise im Bereich zwischen 1 mm und 3 mm liegen. Die Fläche des Heizkörpers 60 (chip size) kann beispielsweise 1 mm x 3 mm oder 2 mm x 3 mm betragen. Die Breite des Heizkörpers 60 liegt vorzugsweise im Bereich zwischen 1 mm und 5 mm, weiter vorzugsweise im Bereich zwischen 2 mm und 4 mm, und beträgt beispielsweise 3 mm. Die Höhe des Heizkörpers 60 liegt vorzugsweise im Bereich zwischen 0,05 mm und 1 mm, weiter vorzugsweise im Bereich zwischen 0,1 mm und 0,75 mm, noch weiter vorzugsweise im Bereich zwischen 0,2 mm und 0,5 mm und beträgt beispielsweise 0,3 mm. Auch noch kleinere Heizkörper können erfindungsgemäß gefertigt und funktionsgerecht betrieben werden.

Die Anzahl der Mikrokanäle 62 liegt vorzugsweise im Bereich zwischen vier und 1000. Auf diese Weise lässt sich der Wärmeeintrag von dem Substrat in die Mikrokanäle 62 optimieren und eine gesicherte hohe Verdampfungsleistung sowie eine ausreichend große Dampfaustrittsfläche realisieren.

Die Mikrokanäle 62 sind in Form eines quadratischen, rechteckigen, vieleckigen, runden, ovalen oder anders geformten Arrays angeordnet, wie in Figur 14 ersichtlich ist. Das Array kann in Form einer Matrix mit s Spalten und z Zeilen ausgebildet sein, wobei s vorteilhaft im Bereich zwischen 2 und 50 und weiter vorteilhaft im Bereich zwischen 3 und 30 und/oder z vorteilhaft im Bereich zwischen 2 und 50 und weiter vorteilhaft im Bereich zwischen 3 und 30 liegt. Auf diese Weise lässt sich eine effektive und auf einfache Weise herstellbare Anordnung der Mikrokanäle 62 mit gesichert hoher Verdampfungsleistung realisieren.

Der Querschnitt der Mikrokanäle 62 kann quadratisch, rechteckig, vieleckig, rund, oval oder anders geformt sein, und/oder sich in Längsrichtung abschnittweise ändern, insbesondere vergrößern, verkleinern oder konstant bleiben.

Die Länge eines oder jedes Mikrokanals 62 liegt vorzugsweise im Bereich zwischen 100 µm und 1000 µm, weiter vorzugsweise im Bereich zwischen 150 µm und 750 µm, noch weiter vorzugsweise im Bereich zwischen 180 µm und 400 µm und beträgt beispielsweise 300 µm. Auf diese Weise lässt sich eine optimale Flüssigkeitsaufnahme und Portionsbildung bei ausreichend gutem Wärmeeintrag von dem Heizkörper 60 in die Mikrokanäle 62 realisieren.

Der Abstand zweier Mikrokanäle 62 beträgt vorzugsweise mindestens das 1,3-fache des lichten Durchmessers eines Mikrokanals 62, wobei der Abstand auf die Mittelachsen der beiden Mikrokanäle 62 bezogen ist. Der Abstand kann bevorzugt das 1,5- bis 5-fache, weiter bevorzugt das 2- bis 4-fache des lichten Durchmessers eines Mikrokanals 62 betragen. Auf diese Weise lässt sich ein optimaler Wärmeeintrag von dem Substrat in die Mikrokanäle und eine ausreichend stabile Anordnung und Wandstärke der Mikrokanäle realisieren.

Aufgrund der vorbeschriebenen Merkmale kann der Heizkörper 60 auch als Volumenheizer bezeichnet werden.

Die Verdampfereinheit 20 weist eine vorzugsweise von der Steuerungsvorrichtung 15 steuerbare Heizspannungsquelle 71 auf, die über Elektroden 72 an gegenüberliegenden Seiten des Heizkörpers 60 mit diesem verbunden ist, so dass eine von der Heizspannungsquelle 71 erzeugte elektrische Spannung Uh zu einem Stromfluss durch den Heizkörper 60 führt. Aufgrund des Ohm'schen Widerstands des elektrisch leitenden Heizkörpers 60 führt der Stromfluss zu einer Erhitzung des Heizkörpers 60 und daher zu einer Verdampfung von in den Mikrokanälen 62 enthaltener Flüssigkeit. Der Heizkörper 60 wirkt somit als Verdampfer. Auf diese Weise erzeugter Dampf/Aerosol entweicht zur Auslassseite 64 aus den Mikrokanälen 62 und wird der Luftströmung 34 beigemischt, siehe Figur 17. Genauer steuert bei Feststellung eines durch Ziehen des Konsumenten verursachten Luftstroms 34 durch den Luftkanal 30 die Steuerungsvorrichtung 15 die Heizspannungsquelle 71 an, wobei durch spontane Erhitzung die in den Mikrokanälen 62 befindliche Flüssigkeit in Form von Dampf/Aerosol aus den Mikrokanälen 62 getrieben wird.

Dabei kann die Dauer der einzelnen Verdampfungsschritte bei unterschiedlichen Temperaturen und/oder einem Verdampfen der einzelnen Komponenten der einzelnen Portionen der Flüssigkeit derart kurz gehalten werden und/oder mit einer Ansteuerfrequenz getaktet erfolgen, dass die schrittweise Verdampfung von einem Konsumenten nicht wahrgenommen und trotzdem eine weitgehend homogene, geschmackskonforme, wiederholbar präzise Aerosolbildung gewährleistet werden kann. Insbesondere erfolgt vorteilhaft zunächst ein Verdampfen einer leichter siedenden Komponente der Flüssigkeit in einem ersten Verdampfungsintervall mit einer ersten Temperatur A und anschließend ein Verdampfen einer höher siedenden Komponente der Flüssigkeit in einem zweiten Verdampfungsintervall mit einer zweiten Temperatur B, welche die Temperatur A übersteigt.

Eine elektronische bzw. elektrische Anbindung des Heizkörpers kann beispielsweise über Klemm-, Feder- oder Presskontakte mit einfacherer Auswechselbarkeit und gegebenenfalls zur Unterstützung von Abdichtungseffekten zur Leckageabsicherung erfolgen und/oder durch wire-bonding oder Löten.

Vorzugsweise ist in dem Datenspeicher des Inhalators 10 eine dem verwendeten Flüssigkeitsgemisch angepasste Spannungskurve Uh(t) hinterlegt. Dies ermöglicht es, den Spannungsverlauf Uh(t) dem verwendeten Liquid angepasst vorzugeben, so dass sich die Heiztemperatur des Heizkörpers 60, und damit auch die Temperatur der kapillaren Mikrokanäle 62, gemäß der bekannten Verdampfungskinetik des jeweiligen Liquids zeitlich über den Verdampfungsvorgang steuern lässt, wodurch optimale Verdampfungsergebnisse erzielbar sind. Die Verdampfungstemperatur liegt vorzugsweise im Bereich zwischen 100 °C und 400 °C, weiter bevorzugt zwischen 150 °C und 350 °C, noch weiter bevorzugt zwischen 190 °C und 290 °C.

An der Einlassseite 61 des Heizkörpers 60 ist eine poröse und/oder kapillare, flüssigkeitsleitende Dochtstruktur 19 angeordnet. Die Dochtstruktur 19 kontaktiert die Einlassseite 61 des Heizkörpers 60 flächig und deckt sämtliche Mikrokanäle 62 einlassseitig ab, wie in den Figuren 14 und 15 ersichtlich ist. An der dem Heizkörper 60 gegenüberliegenden Seite ist die Dochtstruktur flüssigkeitsleitend mit dem Flüssigkeitsspeicher verbunden. Die in den Figuren 14 und 15 gezeigte direkte Anbindung des Flüssigkeitsspeichers 18 an die Dochtstruktur 19 ist nur beispielhaft zu verstehen. Insbesondere können eine Flüssigkeitsschnittstelle und/oder eine mehrere Flüssigkeitsleitungen zwischen Flüssigkeitsspeicher 18 und Dochtstruktur 19 vorgesehen sein. Der Flüssigkeitsspeicher 18 kann daher auch beabstandet von der Dochtstruktur 19 angeordnet sein. Der Flüssigkeitsspeicher 18 kann in seinen Abmessungen größer als die Dochtstruktur 19 sein. Die Dochtstruktur 19 kann beispielsweise in eine Öffnung eines Gehäuses des Flüssigkeitsspeichers 18 eingesetzt sein. Es kann auch eine Mehrzahl von Verdampfereinheiten 20 einem Flüssigkeitsspeicher 18 zugeordnet sein.

Die Dochtstruktur 19 besteht aus porösem und/oder kapillarem Material, das aufgrund von Kapillarkräften in der Lage ist, von dem Heizkörper 60 verdampfte Flüssigkeit in ausreichender Menge von dem Flüssigkeitsspeicher 18 zu dem Heizkörper 60 passiv nachzufördern, um ein Leerlaufen der Mikrokanäle 62 und sich daraus ergebende Probleme zu verhindern.

Die Dochtstruktur 19 besteht vorteilhaft aus einem nichtleitenden Material, um eine unerwünschte Erwärmung von Flüssigkeit in der Dochtstruktur 19 durch Stromfluss zu vermeiden. Die Dochtstruktur 19 besteht vorteilhaft aus einem oder mehreren der Materialien Baumwolle, Cellulose, Acetat, Glasfasergewebe, Glasfaserkeramik, Sinterkeramik, keramisches Papier, Alumosilikat-Papier, Metallschaum, Metallschwamm, einem anderen hitzebeständigen, porösen und/oder kapillaren Material mit geeigneter Förderrate, oder einem Verbund von zwei oder mehr der vorgenannter Materialien. In einer vorteilhaften praktischen Ausführungsform kann die Dochtstruktur 19 mindestens ein Keramikfaserpapier und/oder eine poröse Keramik umfassen. Das Volumen der Dochtstruktur 19 liegt vorzugsweise im Bereich zwischen 1 mm³ und 10 mm³, weiter vorzugsweise im Bereich zwischen 2 mm³ und 8 mm³, noch weiter vorzugsweise im Bereich zwischen 3 mm³ und 7 mm³ und beträgt beispielsweise 5 mm³.

Falls die Dochtstruktur 19 aus einem leitenden Material besteht, was nicht ausgeschlossen ist, ist zwischen der Dochtstruktur 19 und dem Heizkörper 60 vorteilhaft eine Isolierschicht aus einem elektrisch und/oder thermisch isolierenden Material, beispielsweise Glas, Keramik oder Kunststoff, mit sich durch die Isolierschicht erstreckenden, mit den Mikrokanälen 62 korrespondierenden Durchgangsöffnungen vorgesehen.

Die Größe der Poren bzw. Kapillaren in dem Material der Dochtstruktur 19 unterliegt vorteilhaft bestimmten Vorgaben. So ist die mittlere Poren-/Kapillargröße Dw von Poren oder Kapillaren der Dochtstruktur 19 im Kontaktbereich 35, 61 zu dem Heizkörper 60 vorteilhaft minimal, d.h. Dw = Pmin (siehe Figuren 5, 6), und/oder vorteilhaft kleiner, vorzugsweise um mindestens den Faktor 2, weiter vorzugsweise um mindestens den Faktor 5, als der kleinste Abstand Dp zweier Mikrokanäle 62 zueinander, d.h. Dw « Dp, siehe Figur 4. Des Weiteren ist die mittlere Poren-/Kapillargröße Dw von Poren oder Kapillaren der Dochtstruktur 19 im Kontaktbereich 35, 61 zu dem Heizkörper 60 vorteilhaft kleiner, vorzugsweise um mindestens den Faktor 2, weiter vorzugsweise um mindestens den Faktor 5, als der kleinste lichte Durchmesser Dpw eines Mikrokanals 62, d.h. Dw « Dpw.

Die Dochtstruktur 19 im Kontaktbereich 35, 61 zu dem Heizkörper 60 dient dazu, Flüssigkeit gleichmäßig zu verteilen, temperaturbeständig zu sein und mit ihren relativ kleinen Poren und/oder dünnen Kapillaren eine Art Rückschlagventil zu bilden, um unerwünschtes Rückfließen von blasenhaltiger Flüssigkeit aus dem Heizkörper 60 in die Dochtstruktur 19 und/oder in den Flüssigkeitsspeicher 18 zu verhindern.

In der Ausführungsform gemäß Figur 15 weist die Dochtstruktur 19 zwei beispielsweise planare Schichten 35, 36 auf, nämlich eine an der Einlassseite 61 des Heizkörpers 60 flächig anliegende und diese kontaktierende Dochtschicht 35, die als Kontaktschicht bezeichnet werden kann, und eine daran angrenzende Dochtschicht 36, die flüssigkeitsleitend mit dem Flüssigkeitsspeicher 18 verbunden ist und als entferntere Dochtschicht bezeichnet werden kann.

Die Kontaktschicht 35 weist eine in sich im Wesentlichen konstante Poren-/Kapillargrößenverteilung und eine in sich im Wesentlichen konstante mittlere Poren-/Kapillargröße Dw auf, die signifikant kleiner als der kleinste Abstand Dp zweier Mikrokanäle 62 zueinander und signifikant kleiner als der kleinste lichte Durchmesser Dpw eines Mikrokanals 62 ist: Dw « Dp, Dpw.

Die entferntere Dochtschicht 36 weist eine in sich im Wesentlichen konstante Poren-/Kapillargrößenverteilung und eine in sich im Wesentlichen konstante mittlere Poren-/Kapillargröße Dw` auf, die signifikant größer ist als die mittlere Poren-/Kapillargröße Dw der Kontaktschicht 35: Dw' > Dw, aber bevorzugt immer noch kleiner als Dp und/oder Dpw: Dw' < Dp, Dpw.

In einer vorteilhaften praktischen Ausführungsform kann die Kontaktschicht 35 beispielsweise eine Faserpapier- oder Keramikpapierschicht und/oder die Schicht 36 eine poröse Keramik sein.

Selbstverständlich kann die Dochtstruktur 19 mehr als zwei Dochtschichten 35, 36, ... aufweisen. Auch im Falle von mehr als zwei Dochtschichten 35, 36, ... wird die mittlere Poren-/Kapillargröße mit abnehmendem Abstand zu dem Heizkörper 60 vorteilhaft monoton (d.h. von Dochtschicht zu Dochtschicht) geringer und/oder bleibt gleich, und nimmt daher jedenfalls nicht zu.

In der Ausführungsform gemäß Figur 14 besteht die Dochtstruktur 19 nur aus einer Schicht, deren mittlere Poren-/Kapillargröße mit abnehmendem Abstand d zu dem Heizkörper 60 monoton geringer wird.

In sämtlichen Ausführungsformen kann der gewünschte Poren-/Kapillargrößengradient optimal eingestellt und die Flüssigkeitsströmung zum Heizkörper 60 hin verlangsamt und vergleichmäßigt werden.

Die geschilderte Verringerung der mittleren Poren-/Kapillargröße in der Dochtstruktur 19 mit abnehmendem Abstand zum Heizkörper 60 gilt in der Richtung senkrecht zur Einlassseite 61 des Heizkörpers, d.h. senkrecht zur Kontaktfläche zwischen Heizkörper 60 und Dochtstruktur 19, bzw. parallel zum Verlauf der Mikrokanäle 62. Innerhalb einer Sicht mit gleichem Abstand d zu dem Heizkörper 60 ist die mittlere Poren-/Kapillargröße in der Dochtstruktur 19 dagegen vorteilhaft konstant, damit sämtliche Mikrokanäle 62 des Heizkörpers 60 gleichmäßig mit Flüssigkeit versorgt werden.

Die Mikrokanäle 62 sind vorzugsweise mit ihrer Längsachse quer zu den Schichten 19, 35, 36 bzw. allgemeiner zu einer beliebigen Schichtenfolge angeordnet. Auf diese Weise lässt sich ein optimaler Wärmeeintrag von dem Heizkörper 60 in die Mikrokanäle 62 realisieren.

Der Heizkörper 60 kann vorteilhaft aus Teilstücken eines Wafers mit Dünnfilmschichttechnologie hergestellt werden, welcher eine Schichtdicke von vorzugsweise kleiner oder gleich 1000 µm, weiter vorzugsweise 750 µm, noch weiter vorzugsweise kleiner oder gleich 500 µm aufweist. Oberflächen des Heizkörpers 60 können vorteilhaft hydrophil sein. Die Auslassseite 64 des Heizkörpers 60 kann vorteilhaft mikrostrukturiert sein bzw. Mikroausnehmungen (micro grooves) aufweisen.

Die Verdampfereinheit 20 ist so eingestellt, dass eine Flüssigkeitsmenge vorzugsweise im Bereich zwischen 1 µl und 20 µl, weiter vorzugsweise zwischen 2 µl und 10 µl, noch weiter vorzugsweise zwischen 3 µl und 5 µl, typischerweise 4 µl pro Zug des Konsumenten, zudosiert wird. Vorzugsweise kann die Verdampfereinheit 20 hinsichtlich der Flüssigkeits-/Dampfmenge pro Zug, d.h. je Zugdauer von 1 s bis 3 s, einstellbar sein.

Im Folgenden wird beispielhaft der Ablauf eines Verdampfungsvorgangs erläutert.

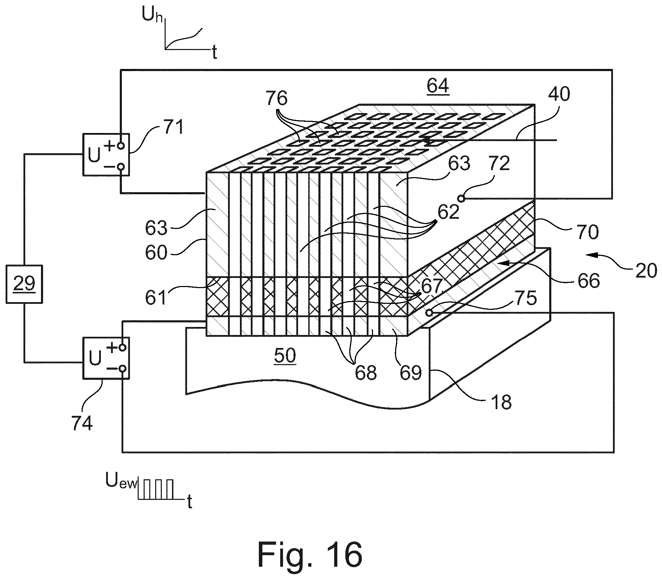

In einem Ausgangszustand ist die Spannungsquelle 71 (Fig. 16; siehe auch Energiespeicher 14 in Fig. 17) für den Heizvorgang ausgeschaltet.

Zum Verdampfen von Flüssigkeit 50 wird die Spannungsquelle 14, 71 für den Heizkörper 60 aktiviert. Die Spannung Uh wird dabei so eingestellt, dass die Verdampfungstemperatur in dem Heizkörper 60 und somit in den Mikrokanälen 62 an das individuelle Verdampfungsverhalten des eingesetzten Flüssigkeitsgemischs angepasst ist. Dies verhindert die Gefahr von lokaler Überhitzung und dadurch Schadstoffentstehung.

Insbesondere kann erfindungsgemäß auch einer unerwünschten differentiellen Verdampfung eines Liquidgemisches entgegengewirkt oder begegnet werden oder eine solche vermieden werden. Ein Liquidgemisch könnte sonst Komponenten aufgrund unterschiedlicher Siedetemperaturen vorschnell im Laufe einer Abfolge von Verdampfungsvorgängen, insbesondere "puffs", verlieren, bevor das Reservoir des Liquids vollständig entleert ist, was beim weiteren Betrieb unerwünschte Effekte bei einem Benutzer nach sich ziehen könnte, insbesondere bei einem pharmazeutisch wirksamen Liquid.

Sobald eine Flüssigkeitsmenge verdampft ist, die dem Volumen der Mikrokanäle 62 entspricht oder damit in Zusammenhang steht, wird die Heizspannungsquelle 14, 71 deaktiviert. Da die Liquideigenschaften und -menge vorteilhaft exakt bekannt sind und der Heizkörper 60 einen messbaren temperaturabhängigen Widerstand aufweist, kann dieser Zeitpunkt sehr genau bestimmt bzw. gesteuert werden. Die Energieaufnahme der Verdampfereinheit 20 lässt sich daher gegenüber bekannten Vorrichtungen reduzieren, da die benötigte Verdampfungsenergie dosierter und damit exakter eingebracht werden kann.

Nach Abschluss des Heizvorgangs sind die Mikrokanäle 62 überwiegend oder vollständig entleert. Die Heizspannung 14, 71 wird dann so lange ausgeschaltet gehalten, bis mittels Nachförderung von Flüssigkeit durch die Dochtstruktur 19 die Mikrokanäle 62 wieder aufgefüllt sind. Sobald dies der Fall ist, kann der nächste Heizzyklus durch Einschalten der Heizspannung 14, 71 begonnen werden.

Die von der Heizspannungsquelle 14, 71 erzeugte Ansteuerfrequenz des Heizkörpers 60 liegt im Allgemeinen vorteilhaft im Bereich von 1 Hz bis 50 kHz, bevorzugt im Bereich von 30 Hz bis 30 kHz, noch weiter vorteilhaft im Bereich von 100 Hz bis 25 kHz.

Die Frequenz und der Tastgrad der Heizspannung Uh für den Heizkörper 60 sind vorteilhaft an die Eigenschwingung bzw. Eigenfrequenz der Blasenschwingungen während der Blasensiedung angepasst. Vorteilhaft kann die Periodendauer 1/f der Heizspannung daher im Bereich zwischen 5 ms und 50 ms, weiter vorteilhaft zwischen 10 ms und 40 ms, noch weiter vorteilhaft zwischen 15 ms und 30 ms liegen und beispielsweise 20 ms betragen. Je nach Zusammensetzung der verdampften Flüssigkeit können andere als die genannten Frequenzen optimal an die Eigenschwingung bzw. Eigenfrequenz der Blasenschwingungen angepasst sein.

Des Weiteren hat sich gezeigt, dass der durch die Heizspannung Uh erzeugten maximale Heizstrom vorzugsweise nicht mehr als 7 A, weiter vorzugsweise nicht mehr als 6,5 A, noch weiter vorzugsweise nicht mehr als 6 A betragen und optimalerweise im Bereich zwischen 4 A und 6 A liegen sollten, um konzentrierten Dampf bei Vermeidung von Überhitzung zu gewährleisten.

Die Förderrate der Dochtstruktur 19 ist wiederum optimal an die an die Verdampfungsrate des Heizkörpers 60 angepasst, so dass jederzeit ausreichend Flüssigkeit nachgefördert werden kann und ein Leerlaufen des Bereichs vor dem Heizkörper 60 vermieden wird.

Ergänzend sei an dieser Stelle vorsorglich darauf hingewiesen, dass eine Steuerung des Verdampfersystems auch über eine Stromregelung statt über eine Spannungsregelung erfolgen kann. In den vorhergehenden Ausführungen kann daher anstatt auf die Spannung Uh sinngemäß auch auf einen Strom Ih Bezug genommen werden.

Die Verdampfereinheit 20 ist vorzugsweise auf der Grundlage von MEMS-Technologie, insbesondere aus Silizium, gefertigt und daher vorteilhaft ein Mikro-Elektro-Mechanisches System.

Vorgeschlagen wird nach dem zuvor Gesagten vorteilhaft ein Schichtaufbau bestehend aus einem vorteilhaft mindestens auf der Einlassseite 61 planaren Heizkörper 60 auf Si-Basis und einer oder mehrerer darunter liegender Kapillarstrukturen 19 mit vorteilhaft unterschiedlicher Porengröße. Die direkt an der Einlassseite 61 des Heizkörpers 60 angeordnete Dochtstruktur 19 verhindert die Bildung von Blasen an der Einlassseite 61 des Heizkörpers 60, da Gasblasen eine weitere Förderwirkung unterbinden und gleichzeitig zu einer (lokalen) Überhitzung des Heizkörpers 60 aufgrund fehlender Kühlung durch nachströmendes Liquid führen. Bei dem erfindungsgemäßen Verfahren könnte auch daran gedacht werden, den Heizkörper gleich zusammen bzw. gemeinsam mit seiner Dochtstruktur zu fertigen bzw. zu versehen.

Eine weitere vorteilhafte Ausführungsform einer erfindungsgemäßen Verdampfereinheit 20 ist in Fig. 16 gezeigt. Die Verdampfereinheit 20 umfasst einen Heizkörper 60 mit einem blockförmigen Halbleitersubstrat 63, vorzugsweise Silizium. Das Substrat 63 ist mit einer Mehrzahl von Mikrokanälen 62 versehen, die eine Einlassseite 61 des Substrats 63 mit einer Auslassseite 64 flüssigkeitsleitend verbinden. Die Einlassseite 61 ist flüssigkeitsleitend mit dem Flüssigkeitsspeicher 18 verbunden. Dies wird im Folgenden noch genauer erläutert.

An der Einlassseite 61 des Substrats 60 ist eine den Durchfluss von Flüssigkeit durch die Mikrokanäle 62 steuernde Durchflusssteuereinrichtung 66 vorgesehen ist. Die Durchflusssteuereinrichtung 66 ist in einer vorteilhaften Ausführungsform eine Durchflusssteuerschicht 69 mit sich durch die Durchflusssteuerschicht 69 erstreckenden Durchgangsbohrungen 68.

Besonders vorteilhaft ist in der Durchflusssteuerschicht 66 ein elektrisches Feld an die Flüssigkeit zum Beeinflussen des Kontaktwinkels zwischen Flüssigkeit und Innenwand einer Durchgangsbohrung 68 anlegbar, wobei vorzugsweise der Effekt der elektrischen Benetzung (electro wetting) genutzt wird. Zu diesem Zweck weist die Verdampfereinheit 20 eine vorzugsweise von einer Steuereinheit 29 steuerbare EW (electro wetting)-Spannungsquelle 74 auf, die über Elektroden 75 an gegenüberliegenden Seiten der Durchflusssteuerschicht 69 mit diesem verbunden ist, so dass eine von der EW-Spannungsquelle 74 erzeugte elektrische Spannung Uew zu einer Verschiebung der Ladungsträger in der Flüssigkeit in den Durchgangsbohrungen 68 führt. Auf diese Weise kann der Kontaktwinkel zwischen Flüssigkeit und Innenwand einer Durchgangsbohrung 68 zwischen hydrophil (Anlegen einer geeigneten Spannung) und hydrophob (keine Spannung) geändert werden. Wenn der Kontaktwinkel in den Durchgangsbohrungen 68 auf hydrophil eingestellt ist, wird die Flüssigkeit aus dem Flüssigkeitsspeicher 18 kapillar in die Durchgangsbohrungen 68 gefördert und kann aufgrund der kapillaren Förderwirkung in die Durchgangsöffnungen 67 und weiter in die Mikrokanäle 62 steigen. Wenn der Kontaktwinkel in den Durchgangsbohrungen 68 auf hydrophob eingestellt ist, ist ein Aufsteigen der Flüssigkeit aus dem Flüssigkeitsspeicher 18 durch die Durchgangsbohrungen 68 in die Durchgangsöffnungen 67 und in die Mikrokanäle 62 gesperrt. Da keine kapillare Förderwirkung auftritt, verbleibt die Flüssigkeit im Flüssigkeitsspeicher 18. Die Funktion der Durchflusssteuerschicht 69 besteht also darin, ein Umschalten zwischen freiem Flüssigkeitsdurchtritt durch die Durchgangsbohrungen 68 und Sperren von Flüssigkeitsdurchtritt durch die Durchgangsbohrungen 68 zu ermöglichen. Die Durchflusssteuerschicht 69 kann daher auch als Schaltschicht bezeichnet werden. Nach dem oben Gesagten dient die Durchflusssteuerschicht 69 zur Steuerung des Befüllvorgangs der Mikrokanäle 62 in dem Verdampfungskörper 60.

Die Durchflusssteuerschicht 69 kann vorteilhaft auch oder zusätzlich als EWOD (electro wetting on dielectrics)-Schicht ausgeführt sein, wobei die Oberfläche der Innenwand Durchgangsbohrungen 68 mit einem geeigneten Dielektrikum beschichtet ist. Ein solches Dielektrikum kann vorteilhaft als self assembled monolayer (SAM) ausgebildet sein, mit welchem der Kontaktwinkel zwischen Flüssigkeit und Innenwand einer Durchgangsbohrung 68 weiter oder zusätzlich beeinflusst werden kann.

Zwischen der Durchflusssteuerschicht 69 und dem Substrat 63 ist vorteilhaft eine Isolierschicht 70 aus einem isolierenden Material, beispielsweise Glas oder Keramik, mit sich durch die Isolierschicht 70 erstreckenden Durchgangsöffnungen 67 vorgesehen. Die Isolierschicht 70 dient dazu, den Verdampfungskörper 60 von dem Flüssigkeitsspeicher 18 thermisch zu isolieren, insbesondere um eine unerwünschte hohe Erwärmung und/oder eine Dampfbildung der Flüssigkeit in dem Flüssigkeitsspeicher 18 während der Verdampfung zu verhindern. Die Isolierschicht 70 kann auch zur elektrischen Isolierung des Substrats 63 von der Durchflusssteuerschicht 69 dienen, wodurch das Verdampfen und/oder Heizen von der Durchflusssteuerung entkoppelt werden kann. Die Durchgangsöffnungen 67 korrespondieren vorzugsweise mit den Mikrokanälen 62 und/oder mit den Durchgangsbohrungen 68, so dass durchgehende Mikrokanäle vom Flüssigkeitsspeicher 18 bis zu den Austrittsöffnungen 76 auf der Austrittsseite 64 des Substrats 63 geschaffen werden.

Die Mikrokanäle 62, Durchgangsöffnungen 67 und/oder Durchgangsbohrungen 68 sind vorzugsweise mit ihrer Längsachse quer zu den Schichten 69, 70 angeordnet. Verallgemeinert sind, wenn durch das Substrat 63 und die Durchflusssteuerschicht 69 und/oder die Isolierschicht 70 und/oder mindestens eine andere Schicht eine Schichtenfolge gebildet ist, die Mikrokanäle 62 mit ihren Längsachsen vorteilhaft quer zu der Schichtenfolge angeordnet. Auf diese Weise lassen sich ein optimaler Wärmeeintrag von dem Substrat 63 in die Mikrokanäle 62 realisieren und die Mikrokanäle 62 von Abdichtungsproblem weitgehend freihalten.

Vorzugsweise und mit besonderem Vorteil können alle Schichten 63, 69, 70 und so weiter mit dem erfindungsgemäßen Verfahren, bevorzugt in wenigstens einem Bereich eines Wafers, gefertigt bzw. ausgebildet werden.

Der in Fig. 17 dargestellte Inhalator 10, hier ein elektronisches Zigarettenprodukt, umfasst ein Gehäuse 11, in dem ein Luftkanal 30 zwischen mindestens einer Lufteinlassöffnung 31 und einer Luftauslassöffnung 24 an einem Mundende 32 des Zigarettenprodukts 10 vorgesehen ist. Das Mundende 32 des Zigarettenprodukts 10 bezeichnet dabei das Ende, an dem der Konsument zwecks Inhalation zieht und dadurch das Zigarettenprodukt 10 mit einem Unterdruck beaufschlagt und eine Luftströmung 34 in dem Luftkanal 30 erzeugt.

Das Zigarettenprodukt 10 besteht vorteilhaft aus einem Basisteil 16 und einer Verbrauchseinheit 17, die die Verdampfereinheit 20 und den Flüssigkeitsspeicher 18 umfasst und insbesondere in Form einer auswechselbaren Kartusche ausgebildet ist. Die durch die Einlassöffnung 31 angesaugte Luft wird in dem Luftkanal 30 zu oder entlang mindestens einer Verdampfereinheit 20 geleitet. Die Verdampfereinheit 20 ist mit mindestens einem Flüssigkeitsspeicher 18 unter anderem mit einer Dochtstruktur 19 flüssigkeitsleitend verbunden oder verbindbar, in dem mindestens eine Flüssigkeit 50 gespeichert ist. Die Verdampfereinheit 20 verdampft durch einen Heizkörper 60 Flüssigkeit 50, die ihr aus dem Flüssigkeitsspeicher 18 zugeführt wird, und gibt die verdampfte Flüssigkeit als Aerosol/Dampf 22 an einer Auslassseite 64 in den Luftstrom 34 zu. Ein vorteilhaftes Volumen des Flüssigkeitsspeichers 18 liegt im Bereich zwischen 0,1 ml und 5 ml, vorzugsweise zwischen 0,5 ml und 3 ml, weiter vorzugsweise zwischen 0,7 ml und 2 ml oder 1,5 ml.

Die elektronische Zigarette 10 umfasst des Weiteren einen elektrischen Energiespeicher 14 als Spannungsquelle und eine elektronische Steuerungsvorrichtung 15. Der Energiespeicher 14 ist in der Regel in dem Basisteil 16 angeordnet und kann insbesondere eine elektrochemische Einweg-Batterie oder ein wiederaufladbarer elektrochemischer Akku, beispielsweise ein Lithium-lonen-Akku, sein. Die elektronische Steuerungsvorrichtung 15 umfasst mindestens eine digitale Datenverarbeitungseinrichtung, insbesondere Mikroprozessor und/oder Microcontroller, in dem Basisteil 16 und/oder in der Verbrauchseinheit 17.

In dem Gehäuse 11 ist vorteilhaft ein Sensor, beispielsweise ein Drucksensor oder ein Druck- oder Strömungsschalter, angeordnet, wobei die Steuerungsvorrichtung 15 auf der Grundlage eines von dem Sensor ausgegebenen Sensorsignals feststellen kann, dass ein Konsument am Mundende 32 des Zigarettenprodukts 10 zieht, um zu inhalieren. In diesem Fall steuert die Steuerungsvorrichtung 15 die Verdampfereinheit 20 an, um Flüssigkeit 50 aus dem Flüssigkeitsspeicher 18 als Aerosol/Dampf in den Luftstrom 34 zuzugeben.

Die in dem Flüssigkeitsspeicher 18 gespeicherte, zu dosierende Flüssigkeit 50 ist beispielsweise eine Mischung aus 1,2-Propylenglykol, Glycerin, Wasser, mindestens einem Aroma (Flavour) und/oder mindestens einem Wirkstoff insbesondere Nikotin.

Die Verbrauchseinheit bzw. Kartusche 17 umfasst vorteilhaft einen nichtflüchtigen Datenspeicher zum Speichern von die Verbrauchseinheit bzw. Kartusche 17 betreffender Information bzw. Parameter. Der Datenspeicher kann Teil der elektronischen Steuerungsvorrichtung 15 sein. In dem Datenspeicher ist vorteilhaft Information zur Zusammensetzung der in dem Flüssigkeitsspeicher 18 gespeicherten Flüssigkeit, Information zum Prozessprofil, insbesondere Leistungs-/Temperatursteuerung; Daten zur Zustandsüberwachung bzw. Systemprüfung, beispielsweise Dichtigkeitsprüfung; Daten betreffend Kopierschutz und Fälschungssicherheit, eine ID zur eindeutigen Kennzeichnung der Verbrauchseinheit bzw. Kartusche 17, Seriennummer, Herstelldatum und/oder Ablaufdatum, und/oder Zugzahl (Anzahl der Inhalationszüge durch den Konsumenten) bzw. der Nutzungszeit gespeichert. Der Datenspeicher ist vorteilhaft über Kontakte und/oder Leitungen mit der Steuereinrichtung 15 verbunden oder verbindbar.

In dem Inhalator 10 und/oder in einem externen Speicher, der in geeigneter und an sich bekannter Weise, zumindest zeitweilig, kommunikationstechnisch mit dem Inhalator verbunden werden kann, könnten auch nutzerbezogene Daten, insbesondere über das Rauchverhalten, gespeichert werden und vorzugsweise auch zur Steuerung oder Regelung des Inhalators genutzt werden.

## Patentansprüche

1. Verfahren zur Fertigung eines elektrisch betreibbaren, insbesondere planaren Heizkörpers für einen Inhalator, insbesondere für ein elektronisches Zigarettenprodukt, vorzugsweise zum Verdampfen von Flüssigkeit, wobei ein vorzugsweise metallfreies Halbleitermaterial im Wesentlichen plattenförmig bereitgestellt wird und eine Mehrzahl von Kanälen im Wesentlichen in Richtung der Flächennormalen des plattenförmigen Halbleitermaterials in das Halbleitermaterial eingearbeitet wird, derart, dass ein Fluid in den Kanälen durch das Halbleitermaterial hindurchleitbar ist, wobei auf das Halbleitermaterial wenigstens bereichsweise, wenigstens eine Beschichtung auf wenigstens einer Seite des Halbleitermaterials aufgebracht wird, wobei die Beschichtung ringförmig und metallisch ist zur Ausbildung von Heizelementen, **dadurch gekennzeichnet, dass** die ringförmige Beschichtung in Abschnitten der Kanäle oder Wandungen der Kanäle ist.

2. Verfahren nach Anspruch 1, **dadurch gekennzeichnet, dass** als Halbleitermaterial im Wesentlichen ein Silizium verwendet wird, vorzugsweise ein Polysilizium verwendet wird.

3. Verfahren nach Anspruch 1 oder 2, **dadurch gekennzeichnet, dass** das Halbleitermaterial durch Dotierung wenigstens bereichsweise in seiner elektrischen Leitfähigkeit verbessert ist.

4. Verfahren nach Anspruch 3, **dadurch gekennzeichnet, dass** das Halbleitermaterial n-dotiert ist, vorzugsweise unter Verwendung von Phosphor.

5. Verfahren nach einem oder mehreren der vorhergehenden Ansprüche, **dadurch gekennzeichnet, dass** das Halbleitermaterial mit elektrischen Kontakten versehen wird, vorzugsweise unter Nutzung einer metallischen Beschichtung.

6. Verfahren nach einem oder mehreren der vorhergehenden Ansprüche, **dadurch gekennzeichnet, dass** das Halbleitermaterial wenigstens bereichsweise oxidiert wird.

7. Verfahren nach einem oder mehreren der vorhergehenden Ansprüche, **dadurch gekennzeichnet, dass** die Kanäle durch, vorzugsweise trockenes Ätzen in dem Halbleitermaterial ausgebildet werden.

8. Verfahren nach Anspruch 7, **dadurch gekennzeichnet, dass** im Wesentlichen ein Reaktives lonenätzen angewendet wird.

9. Verfahren nach einem oder mehreren der vorhergehenden Ansprüche, vorzugsweise nach Anspruch 7 oder 8, **dadurch gekennzeichnet, dass** die Kanäle von beiden Seite des Halbleitermaterials ausgehenden fluidzugänglich ausgebildet werden.

10. Verfahren nach einem oder mehreren der vorhergehenden Ansprüche, **dadurch gekennzeichnet, dass** eine Mehrzahl von Heizelementen auf einem Wafer ausgebildet werden und vorzugsweise anschließend einzelne Heizkörper oder Gruppen von Heizkörpern aus dem Wafer, vorzugsweise als sogenannte Dies, entnommen werden.

11. Verfahren nach Anspruch 7, **dadurch gekennzeichnet, dass** der Heizkörper oder die Heizkörper im Wesentlichen als Nacktchip weiterverwendet werden.

12. Heizkörper für einen Inhalator, vorzugsweise für ein elektronisches Zigarettenprodukt, **dadurch gekennzeichnet, dass** der Heizkörper nach dem Verfahren gemäß einem oder mehreren der Ansprüche 1 bis 6 oder 9 gefertigt ist.

13. Wafer aus einem Halbleitermaterial, **dadurch gekennzeichnet, dass** er eine Mehrzahl von als Heizelemente geeignete Heizkörper aufweist, die nach dem Verfahren gemäß einem oder mehreren der Ansprüche 1 bis 6, 9, vorzugsweise gemäß Anspruch 10, gefertigt oder vorbereitet sind.

## Claims

1. Method for manufacturing an electrically operable, in particular planar heating body for an inhaler, in particular for an electronic cigarette product, preferably for evaporating liquid, wherein a preferably metal-free semiconductor material is provided so as to be substantially planar, and a plurality of channels are incorporated into the semiconductor material substantially in the direction of the surface normal of the planar semiconductor material, such that a fluid can pass through the semiconductor material in the channels, wherein, at least in regions, at least one coating is applied to the semiconductor material on at least one face of the semiconductor material, wherein the coating is annular and metal in order to form of heating elements, **characterised in that** the annular coating in in portions of the channel, or in walls of the channel.

2. Method according to claim 1, **characterised in that** a silicon is substantially used as the semiconductor material, preferably a polysilicon.

3. Method according to either claim 1 or claim 2, **characterised in that** the electrical conductivity of the semiconductor material is improved at least in regions by doping.

4. Method according to claim 3, **characterised in that** the semiconductor material is n-doped, preferably using phosphorus.

5. Method according to one or more of the preceding claims, **characterised in that** the semiconductor material is provided with electrical contacts, preferably using a metal coating.

6. Method according to one or more of the preceding claims, **characterised in that** the semiconductor material is oxidised at least in regions.

7. Method according to one or more of the preceding claims, **characterised in that** the channels are formed in the semiconductor material by, preferably dry, etching.

8. Method according to claim 7, **characterised in that** reactive ion etching is substantially used.

9. Method according to one or more of the preceding claims, preferably according to either claim 7 or claim 8, **characterised in that** the channels are fluidically accessible from both sides of the semiconductor material.

10. Method according to one or more of the preceding claims, **characterised in that** a plurality of heating elements are formed on a wafer, and individual heating bodies or groups of heating bodies are preferably then removed from the wafer, preferably as what are referred to as dies.

11. Method according to claim 7, **characterised in that** the heating body or the heating bodies are further substantially used as a bare chip.

12. Heating body for an inhaler, preferably for an electronic cigarette product, **characterised in that** said heating element is manufactured using the method according to one or more of claims 1 to 6 or 9.

13. Wafer made of a semiconductor material, **characterised in that** it has a plurality of elements which are suitable as heating elements and are manufactured or prepared using the method according to one or more of claims 1 to 6, 9, preferably according to claim 10.

## Revendications

1. Procédé de fabrication d'un corps chauffant électrique, en particulier plan, pour un inhalateur, en particulier pour un produit sous forme de cigarette électronique, de préférence pour la vaporisation de liquide, dans lequel un matériau semi-conducteur, de préférence exempt de métal, est prévu sensiblement en forme de plaque et une pluralité de canaux est ménagée dans le matériau semi-conducteur sensiblement dans la direction de la normale à la surface du matériau semi-conducteur en forme de plaque, de sorte qu'un fluide peut être conduit dans les canaux à travers le matériau semi-conducteur, dans lequel au moins un revêtement est appliqué au moins par zones sur au moins un côté du matériau semi-conducteur, dans lequel le revêtement est annulaire et métallique pour réaliser des éléments chauffants, **caractérisé en ce que** le revêtement annulaire se trouve dans des sections des canaux ou des parois des canaux.

2. Procédé selon la revendication 1, **caractérisé en ce qu'**on utilise sensiblement un silicium, de préférence un polysilicium, comme matériau semi-conducteur.

3. Procédé selon la revendication 1 ou 2, **caractérisé en ce que** la conductivité électrique du matériau semi-conducteur est améliorée par dopage au moins par zones.

4. Procédé selon la revendication 3, **caractérisé en ce que** le matériau semi-conducteur présente un dopage de type n, de préférence par utilisation de phosphore.

5. Procédé selon l'une ou plusieurs des revendications précédentes, **caractérisé en ce que** le matériau semi-conducteur est pourvu de contacts électriques, de préférence par utilisation d'un revêtement métallique.

6. Procédé selon l'une ou plusieurs des revendications précédentes, **caractérisé en ce que** le matériau semi-conducteur est oxydé au moins par zones.

7. Procédé selon l'une ou plusieurs des revendications précédentes, **caractérisé en ce que** les canaux sont réalisés par gravure, de préférence à sec, dans le matériau semi-conducteur.

8. Procédé selon la revendication 7, **caractérisé en ce que** l'on utilise sensiblement une gravure ionique réactive.

9. Procédé selon l'une ou plusieurs des revendications précédentes, de préférence selon la revendication 7 ou 8, **caractérisé en ce que** les canaux sont réalisés de manière à être accessibles aux fluides à partir des deux côtés du matériau semi-conducteur.

10. Procédé selon l'une ou plusieurs des revendications précédentes, **caractérisé en ce qu'**une pluralité d'éléments chauffants sont réalisés sur une plaquette et, de préférence, des éléments chauffants individuels ou des groupes d'éléments chauffants sont ensuite prélevés de la plaquette, de préférence sous forme de ce que l'on appelle des dies.

11. Procédé selon la revendication 7, **caractérisé en ce que** le corps chauffant ou les corps chauffants sont utilisés ensuite sensiblement sous forme de puce nue.

12. Corps chauffant pour un inhalateur, de préférence pour un produit sous forme de cigarette électronique, **caractérisé en ce que** le corps chauffant est fabriqué par le procédé selon l'une ou plusieurs des revendications 1 à 6 ou 9.

13. Plaquette de matériau semi-conducteur, **caractérisée en ce qu'**elle présente une pluralité de corps chauffants adaptés à servir d'éléments chauffants, qui sont fabriqués ou préparés par le procédé selon l'une ou plusieurs des revendications 1 à 6, 9, de préférence selon la revendication 10.
